(19) **Europäisches Patentamt / European Patent Office / Office européen des brevets**

(11) **EP 4 614 198 A1**

(12) **EUROPEAN PATENT APPLICATION**
published in accordance with Art. 153(4) EPC

(43) Date of publication:
**10.09.2025 Bulletin 2025/37**

(21) Application number: **23901162.0**

(22) Date of filing: **08.12.2023**

(51) International Patent Classification (IPC):
*G02B 1/14* (2015.01)  *G02B 1/12* (2006.01)
*G02B 1/04* (2006.01)  *C08J 5/18* (2006.01)
*C08L 79/08* (2006.01)  *C08L 77/00* (2006.01)

(52) Cooperative Patent Classification (CPC):
C08J 5/18; C08L 77/00; C08L 79/08; G02B 1/04;
G02B 1/12; G02B 1/14

(86) International application number:
**PCT/KR2023/020229**

(87) International publication number:
**WO 2024/123145 (13.06.2024 Gazette 2024/24)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **08.12.2022 KR 20220170456**

(71) Applicant: **Kolon Industries, Inc.**
**Seoul 07793 (KR)**

(72) Inventors:
• **YANG, Jong Won**
**Seoul 07793 (KR)**
• **PARK, Hyo Jun**
**Seoul 07793 (KR)**
• **KWON, Kyung Wook**
**Seoul 07793 (KR)**
• **KIM, Han Sol**
**Seoul 07793 (KR)**
• **SHIN, In Ho**
**Seoul 07793 (KR)**

(74) Representative: **Ter Meer Steinmeister & Partner Patentanwälte mbB**
**Nymphenburger Straße 4**
**80335 München (DE)**

(54) **OPTICAL FILM HAVING EXCELLENT DENTING CHARACTERISTICS, AND DISPLAY DEVICE COMPRISING SAME**

(57) The present invention provides an optical film comprising a light-transmissive substrate, wherein the light-transmissive substrate includes: a polymer including repeating units and an organic additive, wherein the repeating units include at least one of imide repeating units and amide repeating units, and the organic additive includes at least one functional group of a hydroxyl group (-OH), a carboxyl group (-COOH), and an aldehyde group (-COH).

## FIG. 1

<u>100</u>

110

EP 4 614 198 A1

**Description**

[Technical Field]

The present disclosure relates to an optical film with excellent dent characteristics and a display device including the same.

[Background Art]

Recently, the use of an optical film instead of glass as a cover window of a display device has been considered with the goal of reducing thickness and weight and increasing the flexibility of the display device. In order for the optical film to be usable as a cover window of a display device, the optical film needs to have superior optical properties and excellent mechanical properties.

Therefore, there is a need for development of a film with excellent mechanical properties such as insolubility, chemical resistance, heat resistance, radiation resistance, and low-temperature properties, as well as excellent optical properties. There is a need for development of an optical film that satisfies both excellent properties such as dent characteristics and impact resistance, and flexibility for application to foldable or rollable devices.

[Disclosure]

[Technical Problem]

Therefore, the present disclosure has been made in view of the above problems, and it is one aspect of the present disclosure to provide an optical film that includes a novel light-transmitting substrate and thus prevents or inhibits moisture from permeating the optical film to prevent or inhibit changes in physical properties due to moisture permeation.

It is another aspect of the present disclosure to provide an optical film that prevents or inhibits changes in physical properties.

It is another aspect of the present disclosure to provide an optical film that includes a novel light-transmitting substrate and thus exhibits improved compression resistance and excellent dent characteristics.

It is another aspect of the present disclosure to provide a display device including an optical film with excellent dent characteristics.

[Technical Solution]

In accordance with one aspect of the present disclosure, provided is an optical film including a light-transmitting substrate, wherein the light-transmitting substrate includes a polymer resin including a repeating unit and an organic additive, wherein the repeating unit includes at least one of an imide repeating unit or an amide repeating unit, and the organic additive includes at least one functional group of a hydroxyl group (-OH), a carboxyl group (-COOH), or an aldehyde group (-COH).

In an embodiment of the present disclosure, the optical film satisfies the following Equation 1:

[Equation 1]

$$1.0 < \text{First modulus}^3 / \text{Second modulus}^3 < 1.5$$

wherein the first modulus is a modulus measured after allowing the optical film with a thickness of 50 $\mu$m to stand at a temperature of 25°C and a humidity of 50% for 2 weeks, and
the second modulus is a modulus measured after measuring the first modulus and then heat-treating the optical film at a temperature of 150°C for 1 hour.

In an embodiment of the present disclosure, the optical film may include a hard coating layer on the light-transmitting substrate and may have a dent index of 3.5 or more,

wherein the dent index is calculated in accordance with the following Equation 2:

[Equation 2]

Dent index = (PS1 + PS2) x pencil hardness x 0.01

wherein PS1 is a compression strength of the light-transmitting substrate,
PS2 is a compression strength of the optical film,
pencil hardness is a pencil hardness of the optical film, and
PS1 is calculated in accordance with the following Equation 3:

[Equation 3]

PS1 = MS + HV1 + (nIT1 x 0.01)

wherein MS is a modulus of the light-transmitting substrate,
HV1 is a Vickers hardness of the light-transmitting substrate, and
nIT1 is a restoration rate of the light-transmitting substrate,
PS2 in Equation 2 is calculated in accordance with the following Equation 4:

[Equation 4]

PS2 = PNS + HV2 + (nIT2 x 0.01)

wherein PNS is a puncture strength of the optical film,
HV2 is a Vickers hardness of the optical film,
nIT2 is a restoration rate of the optical film,
nIT1 and nIT2 are each measured using a nanoindenter under the conditions of 12 mN/12s/Creep 5s/24°C, 40 RH%, and
the puncture strength is measured in accordance with ASTM D4830.

The optical film according to an embodiment of the present disclosure may have PS1 of 55.00 or more.

The optical film according to an embodiment of the present disclosure may have nIT1 of 68 to 100%.

The optical film according to an embodiment of the present disclosure may have HV1 of 47.00 kg/mm$^2$ or more.

The optical film according to an embodiment of the present disclosure may have MS of 7.0 GPa or more.

The hard coating layer may have a thickness of 0.1 to 10 $\mu$m.

The optical film according to an embodiment of the present disclosure may have PS2 of 82.00 or more.

The optical film according to an embodiment of the present disclosure may have nIT2 of 60 to 100%.

The optical film according to an embodiment of the present disclosure may have PNS of 4.0 kgf or more.

The optical film according to an embodiment of the present disclosure may have HV2 of 77.0 kg/mm$^2$ or more.

The optical film according to an embodiment of the present disclosure may have a yellowness index (Y.I.) of 2.41 or less.

The optical film according to embodiment of the present disclosure may have a light transmittance of 90% or more based on a wavelength of 550 nm.

The imide repeating unit and the amide repeating unit may be produced from a diamine-based compound and the organic additive may be present in an amount of 5 to 50 mole parts based on 100 mole parts of the diamine-based compound.

The organic additive may include at least one of a benzene ring or an alicyclic ring, and a sum of the number of the benzene rings and the number of the alicyclic rings may be 10 or less.

In accordance with another aspect of the present disclosure, provided is a display device including a display panel and the optical film disposed on the display panel.

[Advantageous Effects]

One embodiment of the present disclosure provides an optical film that includes a novel light-transmitting substrate and thus prevents or inhibits moisture from permeating the optical film to prevent or inhibit changes in physical properties due to moisture permeation.

As a result, the optical film according to one embodiment of the present disclosure can prevent or inhibit changes in qualities by heat during processing.

Another embodiment of the present disclosure provides an optical film that includes a novel light-transmitting substrate and thus exhibits improved compression resistance and excellent dent characteristics.

Another embodiment of the present disclosure provides a display device including an optical film with excellent dent characteristics.

[Description of Drawings]

FIG. 1 is a cross-sectional view illustrating an optical film according to an embodiment of the present disclosure;

FIG. 2 is a cross-sectional view illustrating an optical film according to an embodiment of the present disclosure;

FIG. 3 is a cross-sectional view illustrating an optical film according to another embodiment of the present disclosure;

FIG. 4 is a cross-sectional view illustrating an optical film according to another embodiment of the present disclosure;

FIG. 5 is a cross-sectional view illustrating an optical film according to another embodiment of the present disclosure;

FIG. 6 is a cross-sectional view illustrating an optical film according to another embodiment of the present disclosure;

FIG. 7 is a cross-sectional view illustrating an optical film according to another embodiment of the present disclosure;

FIG. 8 is a cross-sectional view illustrating a part of a display device according to another embodiment of the present disclosure;

FIG. 9 is an enlarged cross-sectional view illustrating part "P" in FIG. 8; and

FIG. 10 illustrates a van der Waals bond according to an embodiment of the present disclosure.

[Best Mode]

Hereinafter, embodiments of the present disclosure will be described in detail with reference to the accompanying drawings. However, the following embodiments are illustratively provided merely for clear understanding of the present disclosure and do not limit the scope of the present disclosure.

The shapes, sizes, ratios, angles, and numbers disclosed in the drawings for describing embodiments of the present disclosure are merely examples, and the present disclosure is not limited to the illustrated details. Like reference numerals refer to like elements throughout the present specification. In the following description, when a detailed description of relevant known functions or configurations is determined to unnecessarily obscure important points of the present disclosure, the detailed description will be omitted.

In the case in which a term such as "comprise", "have", or "include" is used in the present specification, another part may also be present, unless "only" is also used. Terms in a singular form may include the plural meanings, unless noted to the contrary. Also, in construing an element, the element is to be construed as including an error range, even if there is no explicit description thereof.

In describing a positional relationship, for example, when the positional relationship is described using "on", "above", "below", or "next to", the case of no contact therebetween may be included, unless "immediately" or "directly" is used.

Spatially relative terms, such as "below", "beneath", "lower", "above", and "upper", may be used herein to describe the relationship between a device or element and another device or element, as shown in the figures. It will be understood that spatially relative terms are intended to encompass different orientations of a device during the use or operation of the device, in addition to the orientation depicted in the figures. For example, if a device in one of the figures is turned upside down, elements described as "below" or "beneath" other elements would then be positioned "above" the other elements. The exemplary term "below" or "beneath" can, therefore, encompass the meanings of both "below" and "above". In the same manner, the exemplary term "above" or "upper" can encompass the meanings of both "above" and "below".

In describing temporal relationships, for example, when a temporal order is described using "after", "subsequent", "next", or "before", the case of a non-continuous relationship may be included, unless "immediately" or "directly" is used.

It will be understood that, although the terms "first", "second", etc. may be used herein to describe various elements, these elements are not limited by these terms. These terms are only used to distinguish one element from another. Therefore, a first element could be termed a second element within the technical idea of the present disclosure.

It should be understood that the term "at least one" includes all combinations related with one or more items. For example, "at least one among a first element, a second element, and a third element" may include all combinations of two or more elements selected from among the first, second, and third elements, as well as each of the first, second, and third elements.

Features of various embodiments of the present disclosure may be partially or completely integrated or combined with each other, and may be variously interoperated with each other and driven technically. The embodiments of the present disclosure may be carried out independently from each other, or may be carried out together in an interrelated manner.

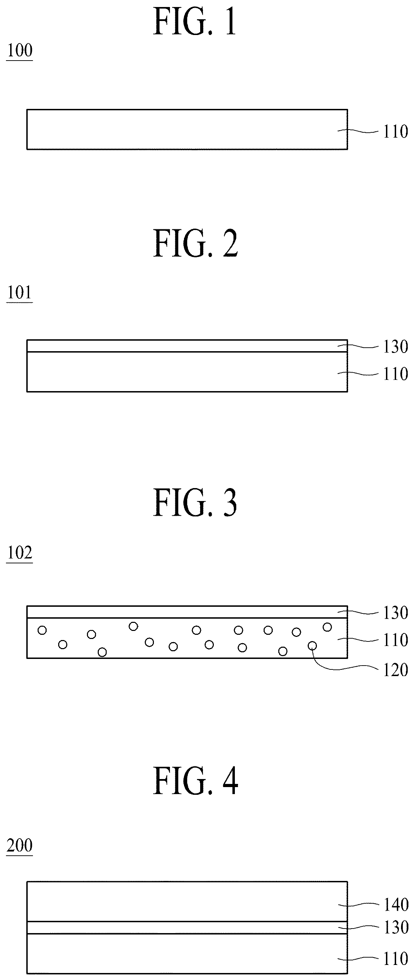

FIG. 1 is a cross-sectional view illustrating an optical film 100 according to an embodiment of the present disclosure.

One embodiment of the present disclosure provides an optical film. According to one embodiment of the present disclosure, the light-transmitting substrate 110 of the optical film includes a polymer and an organic additive.

Specifically, the polymer contains a repeating unit. In this case, the repeating unit may include at least one of an imide repeating unit or an amide repeating unit. For example, the polymer may contain at least one of a polyimide-based polymer, a polyamide-based polymer, or a polyamide-imide-based polymer.

According to one embodiment of the present disclosure, the polymer of the optical film may include an imide repeating unit formed by a diamine-based compound and a dianhydride-based compound.

According to one embodiment of the present disclosure, the polymer of the optical film may include an amide repeating unit formed by a diamine-based compound and a dicarbonyl-based compound. The polymer according to an embodiment of the present disclosure may include both an amide repeating unit and an imide repeating unit formed by a diamine-based compound, a dianhydride-based compound, and a dicarbonyl-based compound.

In general, when an optical film produced from a polyimide-based polymer is allowed to stand outside for a long time, moisture may permeate the optical film and the permeated moisture may form a hydrogen bond with the polyimide-based polymer, thus causing a problem in which the mechanical properties of the optical film are changed.

In addition, when moisture permeates into the optical film, the permeated moisture forms a hydrogen bond with the polyimide-based polymer, and then the manufactured optical film is processed under heat treatment conditions, the water molecules evaporate, thus disadvantageously allowing the hydrogen bond between the polymer and water molecules to be broken and causing the physical properties of the optical film to return to those immediately after production.

According to one embodiment of the present disclosure, the mechanical properties of the optical film may not change even if the optical film is left outside for a long time.

In an embodiment of the present disclosure, the optical film 100 satisfies the following Equation 1:

[Equation 1]

$$1.0 < \text{First modulus}^3 / \text{Second modulus}^3 < 1.5$$

wherein the first modulus is a modulus measured after allowing the optical film with a thickness of 50 $\mu$m to stand at a temperature of 25°C and a humidity of 50% for 2 weeks, and

the second modulus is a modulus measured after measuring the first modulus and then heat-treating the optical film at a temperature of 150°C for 1 hour.

In this case, the modulus of the optical film is measured using a universal tensile tester (MODEL 5967) from Instron Corporation in accordance with ASTM D882.

According to one embodiment of the present disclosure, the optical film 100 may have a value of Equation 1 ranging from 1.0 to 1.5. Preferably, the optical film 100 according to one embodiment of the present disclosure may have a value of Equation 1 of 1.0 to 1.45.

According to one embodiment of the present disclosure, when the optical film 100 has a value of Equation 1 of 1.0 to 1.5, the degree to which the mechanical properties of the optical film change may be reduced even if the optical film is left outside for a long time.

In order to maintain the value of Equation 1 of the optical film 100 at 1.0 to 1.5, the light-transmitting substrate 110 of the optical film 100 according to one embodiment of the present disclosure may contain a polymer and an organic additive.

Specifically, the organic additive may form a hydrogen bond with the polymer.

More specifically, the organic additive may form a hydrogen bond with at least two different polymers.

According to one embodiment of the present disclosure, the repeating unit of the polymer may include at least one of an imide repeating unit or an amide repeating unit.

With respect to hydrogen bond, the organic additive includes at least one functional group selected from the group consisting of a hydroxyl group (-OH), a carboxyl group (-COOH), and an aldehyde group (-COH), and at least two of the functional groups contained in the organic additive may form hydrogen bonds with polymer compounds. At this time, at least two of the functional groups may be identical to or different from each other.

On the other hand, when an organic additive is not contained in the polymer binder, moisture permeates the optical film and the permeated moisture forms a hydrogen bond with the polyimide-based polymer, thus unintentionally increasing the changes in mechanical properties of the optical film over time.

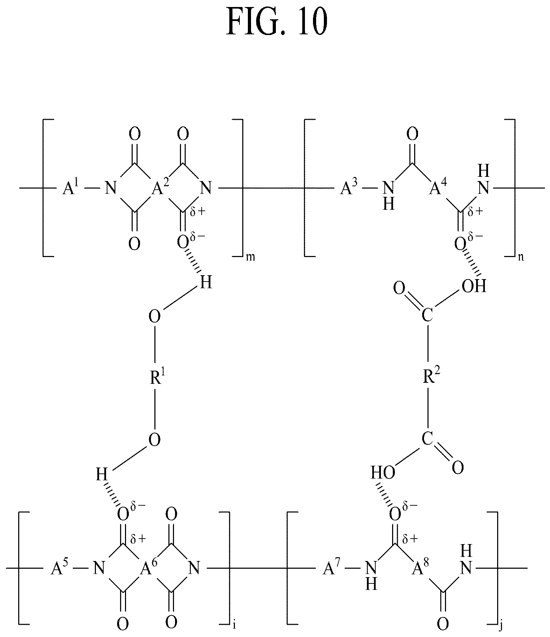

FIG. 10 illustrates a hydrogen bond according to an embodiment of the present disclosure. The hydrogen bond between the polymer and the organic additive will be described with reference to FIG. 10.

In FIG. 10, the repeating unit including $A^1$ and $A^2$ is an imide repeating unit and $A^1$ represents a divalent organic group. For example, $A^1$ includes a divalent organic group having 4 to 40 carbon atoms. The hydrogen atom in the organic group may be substituted with a halogen element, a hydrocarbon group, or a hydrocarbon group substituted with halogen. Here, the number of carbon atoms of the hydrocarbon group or the hydrocarbon group substituted with halogen may be 1 to 8. For example, the hydrogen in $A^1$ may be substituted with -F, $-CH_3$, $-CF_3$, or the like.

$A^2$ represents a tetravalent organic group. For example, $A^2$ may include a tetravalent organic group having 4 to 40 carbon atoms. A hydrogen atom in the organic group may be substituted with a halogen element, a hydrocarbon group, or a hydrocarbon group substituted with halogen. Here, the number of carbon atoms of the hydrocarbon group or the hydrocarbon group substituted with halogen may be 1 to 8.

In FIG. 10, the repeating unit including $A^3$ and $A^4$ is an imide repeating unit and $A^3$ represents a divalent organic group. For example, $A^3$ includes a divalent organic group having 4 to 40 carbon atoms. The hydrogen atom in the organic group may be substituted with a halogen element, a hydrocarbon group, or a hydrocarbon group substituted with halogen. Here, the number of carbon atoms of the hydrocarbon group or the hydrocarbon group substituted with halogen may be 1 to 8. For example, the hydrogen in $A^3$ may be substituted with -F, $-CH_3$, $-CF_3$, or the like.

$A^4$ represents a divalent organic group. For example, $A^4$ may include a divalent organic group having 4 to 40 carbon atoms. $A^4$ may represent a carbon atom, a nitrogen atom, or an oxygen atom. The hydrogen atom in the organic group may be substituted with a halogen element, a hydrocarbon group, or a hydrocarbon group substituted with fluorine. Here, the number of carbon atoms of the hydrocarbon group or the hydrocarbon group substituted with halogen may be 1 to 8.

The compound containing $R^1$ and $R^2$ in FIG. 10 is an organic additive. In FIG. 10, each of $R^1$ and $R^2$ represents a divalent organic group, but an embodiment of the present disclosure is not limited thereto and $R^1$ and $R^2$ may be a divalent to tetravalent organic group. The hydrogen in the organic group may be substituted with a halogen element, a hydrocarbon group, or a hydrocarbon group substituted with halogen.

In FIG. 10, the repeating unit including $A^5$ and $A^6$ is an imide repeating unit, and $A^5$ and $A^6$ correspond to $A^1$ and $A^2$, respectively, and thus detailed descriptions thereof are omitted. In addition, the repeating unit including $A^7$ and $A^8$ is an amide repeating unit, and $A^7$ and $A^8$ correspond to $A^3$ and $A^4$, respectively, and thus detailed descriptions thereof are omitted.

In FIG. 10, m, n, i, and j may be integers of 1 or more.

FIG. 10 shows the hydrogen bond between a polymer including an imide repeating unit and an amide repeating unit, and an organic additive. Specifically, the imide repeating unit and the amide repeating unit of the polymer may have oxygen (O) and the organic additive may have a hydroxyl group (-OH), a carboxyl group (-COOH), or an aldehyde group (-COH). At this time, the hydroxyl group (-OH), carboxyl group (-COOH), and aldehyde group (-COH) of the organic additive form a hydrogen bond with the oxygen (O) of the imide repeating unit and the amide repeating unit.

FIG. 10 is a schematic diagram illustrating an organic additive including a hydroxyl group (-OH) and a carboxyl group (-COOH) as an example of the organic additive, and an embodiment of the present disclosure is not limited thereto and an organic additive including an aldehyde group (-COH) is possible.

In addition, referring to FIG. 10, the functional group of the organic additive is formed in two directions, and the functional group formed in two directions may form a hydrogen bond with the polymer including an imide repeat unit and an amide repeat unit.

According to one embodiment of the present disclosure, the imide repeating unit and the amide repeating unit may be produced from a diamine-based compound and the organic additive may be present in an amount of 5 to 50 mole parts based on 100 mole parts of the diamine-based compound.

Specifically, when the optical film contains the organic additive in an amount of 5 to 50 mole parts with respect to 100 mole parts of the diamine-based compound, the hydrogen bond between the polymer and the organic additive can be formed efficiently, and as a result, moisture permeation into the optical film can be prevented or suppressed even if the optical film is left outside for a long time. As a result, it is possible to prevent or suppress changes in the mechanical properties of the optical film.

In addition, when the optical film contains an organic additive of 5 to 50 mole parts with respect to 100 mole parts of the diamine-based compound, even if the manufactured optical film is processed under heat treatment conditions, the hydrogen bond between the organic additive and the polymer is stronger than the hydrogen bond between moisture and the polymer, and thus is not easily broken even under heat treatment conditions. As a result, even if the optical film is used in a high-temperature process, or the like, it is possible to prevent or inhibit changes in the mechanical properties of the optical film.

On the other hand, when the optical film contains less than 5 mole parts of the organic additive with respect to 100 mole parts of the diamine-based compound, the hydrogen bond between the polymer and the organic additive is not sufficient, and when the optical film is left outside for a long time, moisture readily permeates the optical film, and as a result, the mechanical properties of the optical film may easily change.

In addition, when the optical film contains the organic additive in an amount of less than 5 mole parts with respect to 100 mole parts of the diamine-based compound, the hydrogen bond between the polymer and the organic additive is not sufficient, and moisture may permeate into the optical film, the permeated moisture forms a hydrogen bond with the polyimide-based polymer. When the produced optical film is processed under heat treatment conditions, the water molecules evaporate, and the hydrogen bond between the polymer and water molecules is broken, disadvantageously causing the physical properties to return to those immediately after production.

In addition, when the optical film contains the organic additive in in an amount higher than 50 mole parts with respect to 100 mole parts of the diamine-based compound, the improvement in mechanical properties is insufficient even if the organic additive is further added, and a problem occurs in which optical properties or elongation at break characteristics are deteriorated due to the organic additive added in excessive amount.

According to one embodiment of the present disclosure, the organic additive may include at least one of a benzene ring or an alicyclic ring.

Specifically, the sum of the number of benzene rings and the number of alicyclic rings included in the organic additive may be 10 or less. That is, when the sum of the number of benzene rings and the number of alicyclic rings included in the organic additive is 10 or less, the hydrogen bond between the polymer and the organic additive can be formed efficiently, and as a result, even if the optical film is left outside for a long time, it is possible to prevent or suppress moisture from permeating the optical film. As a result, it is possible to prevent or suppress changes in the mechanical properties of the optical film.

On the other hand, when the sum of the number of benzene rings and the number of alicyclic rings included in the organic additive is more than 10, the polymer may have difficulty forming a hydrogen bond with the organic additive. For this reason, when the optical film is left outside for a long time, moisture may easily permeate the optical film, and as a result, the mechanical properties of the optical film may easily change.

According to one embodiment of the present disclosure, the organic additive may have a Td (50%) of 180° C or higher. Specifically, the organic additive including at least one functional group of a hydroxyl group (-OH), a carboxyl group (-COOH), or an aldehyde group (-COH) should have Td (50%) of 180°C or higher.

Here, Td (50%) refers to the temperature at which 50% by weight of the total weight of the organic additive is reduced.

Specifically, Td (50%) was obtained by thermal analysis of 2g of a sample using model Q500 from TA Instruments as TGA (thermal gravimetric analysis) equipment. The analysis was performed from 25°C to 700°C at a heating rate of 10°C/min to obtain mass loss data as a function of temperature. During analysis, the weight of the sample at 25°C was assumed to be 100%, the temperature at which 1% of the weight was reduced was defined as "Td (1%)", and the temperature at which 5% of the weight was reduced was defined as "Td (5%)".

Even when an optical film is produced at a high temperature, the Td (50%) of the organic additive should be 180°C or higher to maintain the bond between the polymer and the organic additive.

On the other hand, when the optical film is produced at a high temperature, the organic additive having a Td (50%) of less than 180°C may be thermally decomposed, thus making it difficult to maintain the mechanical properties of optical films. Specifically, polyimide or polyamideimide-based optical films are generally produced at a high temperature of 200°C or more. When optical films are produced at high temperatures, organic additives are thermally decomposed, thus making it difficult to maintain mechanical properties of optical films.

According to one embodiment of the present disclosure, the organic additive may include at least one of terephthalic acid, isophthalic acid, 1,3,5-benzenetricarboxylic acid, 1,2,3,4-cyclobutanetetracarboxylic acid, biphenyl-4,4'-dicarboxylic acid, diphenic acid, bisphenol A (diphenylolpropane), hydroquinone, 4,4'-(perfluoropropane-2,2'-diyl)diphthalic acid (6FTA), or pyromellitic acid (PMTA).

The optical film 100 according to an embodiment of the present disclosure may have a yellowness index (Y.I.) of 2.41 or less based on a thickness of 55 μm. The yellowness index of the optical film 100 may be measured at a wavelength of 360 to 740 nm using a spectrophotometer according to ASTM E313. The spectrophotometer may, for example, be CM-3700D from KONICA MINOLTA.

The optical film 100 according to an embodiment of the present disclosure may have a first modulus of 7.0 GPa or more and a second modulus of 6.0 GPa or more.

The definitions and measurement method of the first modulus and the second modulus have already been described above and are thus omitted.

The optical film 100 according to an embodiment of the present disclosure may have a third modulus of 6.0 GPa or more.

The third modulus refers to the modulus of an optical film with a thickness of 50 $\mu$m measured within 3 hours after manufacturing the optical film.

The method of measuring modulus has been described above and a detailed description thereof is thus omitted.

The optical film 100 according to an embodiment of the present disclosure may have an elongation at break of 10% or more based on a thickness of 50 $\mu$m. The elongation at break was measured in accordance with the standard of ASTM-D882 using 5967 from Instron Corporation. The size of the specimen was 10 mm $\times$ 100 mm, the load cell was 30 KN, the grip was 250N, and the tension rate was 25 mm/min.

When the optical film 100 according to an embodiment of the present disclosure has an elongation at break of less than 10% based on a thickness of 50 $\mu$m, disadvantageously, permanent deformation may occur when an external force is applied to the optical film and restoration to the original state may be not possible.

The optical film 100 according to an embodiment of the present disclosure may have a Vickers hardness (HV) of 40 or more based on a thickness of 50 $\mu$m. The Vickers hardness of the optical film 100 is obtained by measuring the surface hardness to the indentation created when pressing the light-transmitting matrix with a thickness of 50 $\mu$m with a pyramidal diamond tip. The Vickers hardness was calculated as HV1 = A/B, wherein A is the load (kg) and B is the surface area (mm$^2$). The Vickers hardness was measured using, for example, a Vickers hardness meter, HM-2000 from Fisher.

When the optical film 100 according to an embodiment of the present disclosure has a Vickers hardness (HV) of less than 40 based on a thickness of 50 $\mu$m, it may be vulnerable to external scratches. In other words, when external force is applied to the outside of the optical film, scratches or cracks may easily occur.

FIG. 2 is a cross-sectional view of the optical film 101 according to an embodiment of the present disclosure.

One embodiment of the present disclosure provides an optical film 101. As shown in FIG. 2, the optical film 101 according to an embodiment of the present disclosure includes a light-transmitting substrate 110 and a hard coating layer 130 on the light-transmitting substrate 110.

Any material may be used as the light-transmitting substrate 110 according to an embodiment of the present disclosure as long as it can transmit light. For example, the light-transmitting substrate 110 may include a polymer. The polymer is suitable for use as a cover window for flexible displays due to excellent bending properties and impact resistance.

The polymer may be contained in the film in various shapes and forms, such as a solid powder, a form dissolved in a solution, a matrix form solidified after being dissolved in a solution, etc. Any resin including the same repeating unit as the resin of the present disclosure may be considered the same as the polymer resin of the present disclosure, regardless of the shape and form thereof. In general, the polymer in the film may be present as a solidified matrix obtained by applying a polymer resin solution, followed by drying.

The polymer according to an embodiment of the present disclosure may be any light-transmitting resin. For example, the polymer resin may include at least one selected from cycloolefin-based derivatives, cellulose-based polymers, ethylene vinyl acetate-based copolymers, polyester-based polymers, polystyrene-based polymers, polyamide-based polymers, polyamide-imide-based polymers, polyetherimide-based polymers, polyacryl-based polymers, polyimide-based polymers, polyether sulfone-based polymers, polysulfone-based polymers, polyethylene-based polymers, polypropylene-based polymers, polymethylpentene-based polymers, polyvinyl chloride-based polymers, polyvinylidene chloride-based polymers, polyvinyl alcohol-based polymers, polyvinyl acetal-based polymers, polyether ketone-based polymers, polyether ether ketone-based polymers, polymethyl methacrylate-based polymers, polyethylene terephthalate-based polymers, polybutylene terephthalate-based polymers, polyethylene naphthalate-based polymers, polycarbonate-based polymers, polyurethane-based polymers, and epoxy-based polymers.

The polymer according to an embodiment of the present disclosure may include at least one of an imide repeating unit and an amide repeating unit. For example, the polymer according to an embodiment of the present disclosure may include at least one of a polyimide-based polymer, a polyamide-based polymer, or a polyamide-imide-based polymer.

The light-transmitting substrate 110 according to an embodiment of the present disclosure may include an imide repeating unit produced from the diamine-based compound and the dianhydride-based compound.

The light-transmitting substrate 110 according to an embodiment of the present disclosure may include an amide repeating unit produced from the diamine-based compound and the dicarbonyl-based compound.

The light-transmitting substrate 110 according to an embodiment of the present disclosure may include an amide repeating unit and an imide repeating unit produced from the diamine-based compound, the dianhydride-based compound, and the dicarbonyl-based compound.

The light-transmitting substrate 110 according to an embodiment of the present disclosure may be any one of polyimide-based substrates, polyamide-based substrates, and polyamide-imide-based substrates. However, the embodiments of the present disclosure are not limited thereto and any substrate may be used as the light-transmitting substrate 110, as long as it is light-transmitting.

The optical film 101 according to an embodiment of the present disclosure may include a hard coating layer 130 on a light-transmitting substrate 110.

According to another embodiment of the present disclosure, the light-transmitting substrate 110 may have an upper surface and a lower surface that is opposite to the upper surface.

According to one embodiment of the present disclosure, the hard coating layer 130 may be formed on any one surface of the light-transmitting substrate 110.

Although not shown in the drawing, the hard coating layer 130 may be disposed on both the upper and lower surfaces of the light-transmitting substrate 110, for example. The hard coating layer 130 may be placed in an arbitrary position as needed and another layer may be formed between the light-transmitting substrate 110 and the hard coating layer 130. However, when the hard coating layer 130 is formed on the lower surface of the light-transmitting substrate 110, the hardness of the optical film 100 may be lowered and thus the durability and scratch resistance of the optical film 100 may be reduced. Accordingly, the hard coating layer 130 may be formed on the upper surface of the light-transmitting substrate 110, for example.

The optical film 101 including the hard coating layer 130 according to an embodiment of the present disclosure may have excellent mechanical properties. For example, the optical film 101 according to an embodiment of the present disclosure may have excellent compressive strength and excellent dent characteristics.

FIG. 3 is a cross-sectional view illustrating the optical film 102 according to another embodiment of the present disclosure.

The optical film 102 according to another embodiment of the present disclosure may further include a filler 120 dispersed in the light-transmitting substrate 110.

The filler 120 according to another embodiment of the present disclosure may be an organic material or an inorganic material. The filler 120 according to another embodiment of the present disclosure may include both organic and inorganic materials.

The filler 120 according to another embodiment of the present disclosure may include at least one of a particle filler or a spherical filler.

The filler 120 according to another embodiment of the present disclosure may have a particle or spherical shape.

According to another embodiment of the present disclosure, the filler 120 may have a spherical shape having a diameter from several tens of nm to several $\mu$m.

The filler 120 according to another embodiment of the present disclosure may include an inorganic filler having a diameter of 50 nm to 5 $\mu$m.

The filler 120 according to another embodiment of the present disclosure may include a spherical filler having a diameter of 2 nm to 20 nm.

The filler 120 according to another embodiment of the present disclosure may be surface-treated with a compound having at least one functional group of -COOH or -OH.

The light-transmitting substrate 110 according to another embodiment of the present disclosure may further include a surface-treated filler 120 that is mixed with at least one of an imide repeating unit or an amide repeating unit.

The filler 120 may have various types depending on the purpose or application. For example, by further including the filler 120 dispersed in the light-transmitting substrate 110, the mechanical properties of the light-transmitting substrate 110 or the optical film 102 including the light-transmitting substrate 110 can be improved.

The optical films 200, 201, and 202 according to another embodiment of the present disclosure may further include an optical compensation layer 140 on the light-transmitting substrate 110.

FIGS. 4, 5, and 6 are cross-sectional views illustrating optical films 200, 201, and 202, respectively, according to another embodiment of the present disclosure.

Referring to FIG. 4, the optical film 200 according to another embodiment of the present disclosure may further include an optical compensation layer 140 disposed on the upper surface of the hard coating layer 130.

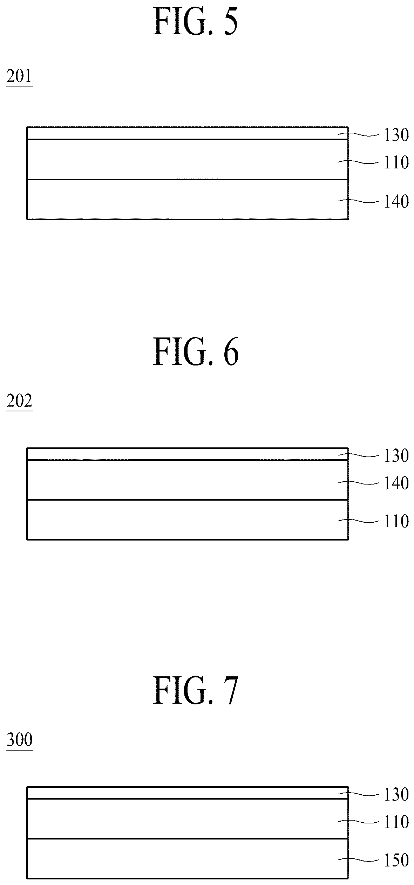

Referring to FIG. 5, the optical film 201 according to another embodiment of the present disclosure may further include an optical compensation layer 140 disposed on the lower surface of the light-transmitting substrate 110.

Referring to FIG. 6, the optical film 202 according to another embodiment of the present disclosure may further include an optical compensation layer 140 disposed between the light-transmitting substrate 110 and the hard coating layer 130.

Although not shown in the drawing, the optical film according to another embodiment of the present disclosure may include, for example, an optical compensation layer 140 disposed on both the upper and lower surfaces of the light-transmitting substrate 110.

By adjusting the refractive index of the optical compensation layer 140 depending on the refractive index of the light-transmitting substrate 110 and the hard coating layer 130, visibility of the optical film 100 can be improved.

FIG. 7 is a cross-sectional view illustrating an optical film 300 according to another embodiment of the present disclosure.

The optical film 300 according to another embodiment of the present disclosure may further include a buffer layer 150 on the light-transmitting substrate 110. The buffer layer may serve to support the optical film 300 and thus can improve the resistance of the optical film 300 to external force.

According to one embodiment of the present disclosure, the optical film 101 may further include a light-transmitting substrate 110 and a hard coating layer 130 on the light-transmitting substrate 110, and the optical film 101 has a dent index of 3.5 or more.

According to one embodiment of the present disclosure, the dent index of the optical film 101 may be calculated using Equation 2 below:

$$[\text{Equation 2}]$$

$$\text{Dent index} = (PS1 + PS2) \times \text{pencil hardness} \times 0.01$$

wherein PS1 is the compressive strength of the light-transmitting substrate 110 according to an embodiment of the present disclosure, PS2 is the compressive strength of the optical film 101 according to an embodiment of the present disclosure, and pencil hardness is the compressive strength of the optical film 101 according to an embodiment of the present disclosure. PS1, PS2 and pencil hardness will be described in detail below with reference to Equations 3 and 4 below.

In Equation 2, the dent index is calculated using only the values excluding the unit of each component. In this case, PS1 and PS2, which are components of the dent index, are also calculated using only the values excluding units, and pencil hardness among the components of the dent index is limited to optical films of H or higher.

According to one embodiment of the present disclosure, the dent index is a numerical representation of the surface characteristics of the optical film 101. Specifically, the dent index is a numerical representation of the degree of traces of deformation generated in the optical film 101 by external force. As the dent index of the optical film 101 increases, the resistance to deformation due to external force increases. The deformation due to external force includes, for example, indentation by a touch pen.

When the dent index of the optical film 101 is 3.5 or more, for example, even if the display device on which the optical film 101 is placed is repeatedly used with a touch pen, it is possible to prevent indentation after the use of the touch pen from remaining on the optical film 101.

When the dent index of the optical film 101 is less than 3.5, for example, when external force by a touch pen is applied to the optical film 101, indentation may remain after the use of the touch pen on the optical film 101.

According to one embodiment of the present disclosure, the dent index of the optical film 101 may be adjusted to 48 or less. For example, the dent index may range from 3.5 to 32, specifically, from 3.8 to 24, and more specifically, from 4.0 to 18.

When the dent index of the optical film 101 is greater than 48, the hard coating layer may become extremely thick, thus making it difficult to maintain the folding characteristics of the optical film 101. In addition, the optical film 101 may be inapplicable to foldable or rollable devices.

According to one embodiment of the present disclosure, the compressive strength is a numerical representation of the pressing resistance.

According to one embodiment of the present disclosure, PS1 in Equation 2 may be calculated by Equation 3 below:

$$[\text{Equation 3}]$$

$$PS1 = MS + HV1 + (nIT\ 1 \times 0.01)$$

wherein PS1 is calculated with only the numbers excluding the unit of each component, and
MS is the modulus of the light-transmitting substrate 110 according to an embodiment of the present disclosure. The basic unit of modulus is GPa.

In Equation 3, MS is, for example, measured under the condition of 25°C/50RH% and 25 mm/min using a universal testing machine (UTM) in accordance with the standard ASTM D882 based on a specimen of a light-transmitting substrate 110 having a thickness of 50 $\mu$m, a width of 10 mm, and a length of 100 mm. The MS of the light-transmitting substrate 110 may be measured using a universal testing machine, for example, a universal testing machine from INSTRON.

The light-transmitting substrate 110 according to an embodiment of the present disclosure may have an MS of 7.0 GPa or more. Specifically, MS may range from 7.0 to 20 GPa.

The light-transmitting substrate 110 according to an embodiment of the present disclosure may have an MS of 7.2 GPa or more. Specifically, MS may range from 7.2 to 12 GPa.

When MS is less than 7.0 GPa, the light-transmitting substrate 110 may be easily deformed or broken by external force.

In Equation 3, HV1 is the Vickers hardness of the light-transmitting substrate 110. The unit of Vickers hardness is $kg/mm^2$.

In Equation 3, the Vickers hardness of the optical film 100 according to an embodiment of the present disclosure is obtained by measuring the surface hardness to the indentation created when pressing the light-transmitting matrix 110 with a pyramidal diamond tip, and calculating HV1 = A/B, wherein A is the load (kg) and B is the surface area ($mm^2$). HV1 may be measured using, for example, a light-transmitting substrate 110 having a thickness of 50 $\mu$m, and the Vickers hardness of the light-transmitting substrate may be measured using, for example, a Vickers hardness meter, HM-2000 from Fisher.

The light-transmitting substrate 110 according to an embodiment of the present disclosure may have HV1 of 47.00 or more. Specifically, HV1 may range from 47.00 to 80.00.

For example, the light-transmitting substrate 110 according to an embodiment of the present disclosure may have HV1 of 49.00 or more. Specifically, HV1 may range from 49.00 to 60.00.

When the HV1 of the light-transmitting substrate 110 is less than 47.00, the optical film 101 may be easily deformed by external force.

In Equation 3, nIT 1 represents the restoration rate of the light-transmitting substrate 110. The basic unit of restoration rate is percentage (%).

nIT 1 may be measured using a nanoindenter under the following conditions: load: 12 mN/load time: 12s/Creep holding time: 5s/temperature: 24°C, humidity: 40 RH%. The nanoindenter may be, for example, HM2000 from Fischer.

The light-transmitting substrate 110 according to an embodiment of the present disclosure may have nIT 1 of 68 to 100% based on 12 mN.

When the nIT 1 of the light-transmitting substrate 110 is less than 68%, the restoration force of the light-transmitting substrate 110 when folded and unfolded is insufficient, and fold indentations or pressing indentations may remain. For this reason, the light-transmitting substrate 110 may be inapplicable to foldable or rollable displays.

The light-transmitting substrates 110 that satisfy these conditions include polyimide substrates, polyamide substrates, and polyamide-imide substrates.

The light-transmitting substrate 110 according to an embodiment of the present disclosure may have PS1 of 55.00 or more. PS1 is a parameter calculated using the modulus, Vickers hardness, and restoration rate of the light-transmitting substrate 110. PS1 of 55.00 or more means that the light-transmitting substrate 110 has excellent surface properties.

Due to the characteristics of the light-transmitting substrate 110 according to an embodiment of the present disclosure, PS1 may be 166.00 or less. For example, PS1 may range from 55.00 to 116.00, specifically, from 57.00 to 90.00, and more specifically, from 57.67 to 72.00.

PS2 of the optical film 101 according to an embodiment of the present disclosure may be calculated by Equation 4 below:

$$[Equation\ 4]$$

$$PS2 = PNS + HV2 + (nIT\ 2\ x\ 0.01)$$

wherein PS2 is calculated with only the numbers excluding the units of each component, and

PNS is a puncture strength of the optical film 101. The unit of puncture strength is kgf.

PNS may be measured using a universal testing machine in accordance with ASTM D4830. For example, when a load is applied to the center of the optical film 101 according to an embodiment of the present disclosure at a constant speed using a probe with a size of 3.18 mm, a universal testing machine from Instron Corporation as the universal testing machine and S1-11855 as a jig, a load at which the optical film 101 punctures is measured and is defined as PNS. PNS may be measured using, for example, an optical film 101 having a thickness of 55 $\mu$m.

The optical film 101 according to an embodiment of the present disclosure may have PNS of 4.0 kgf or more. Specifically, PNS may range from 4.0 to 12.0 kgf.

For example, the optical film 101 according to an embodiment of the present disclosure may have PNS of 4.1 kgf or more. Specifically, PNS may range from 4.1 to 8.0 kgf.

When the PNS is less than 4.0 kgf, the optical film 101 may be easily deformed or damaged by external force.

In Equation 4, HV2 is the Vickers hardness of the optical film 101 according to an embodiment of the present disclosure. The unit of Vickers hardness is $kg/mm^2$.

In Equation 4, the Vickers hardness of the optical film 101 is obtained by measuring the surface hardness to the indentation created when pressing the optical film 101 with a pyramidal diamond tip, and calculating HV2 = C/D, wherein C is the load (kg) and D is the surface area ($mm^2$). HV2 may be measured using, for example, an optical film 101 having a thickness of 55 $\mu$m, and the Vickers hardness of the optical film 101 may be measured using, for example, a Vickers hardness meter, HM-2000 from Fisher.

The optical film 101 according to an embodiment of the present disclosure may have HV2 of 77.00 or more. Specifically, HV2 may range from 77.00 to 110.00.

For example, the optical film 101 according to an embodiment of the present disclosure may have HV2 of 79.00 or more. Specifically, HV2 may range from 79.00 to 90.00.

When the HV2 of the optical film 101 is less than 77.00, the optical film 101 may be easily deformed by external force.

In Equation 4, nIT 2 represents the restoration rate of the optical film 100. The basic unit of nIT 2 is percentage (%).

nIT 2 may be measured using a nanoindenter under the following conditions: load: 12 mN/load time: 12s/Creep holding time: 5s/temperature: 24°C, humidity: 40 RH%. The nanoindenter may be, for example, HM2000 from Fischer.

The optical film 100 according to an embodiment of the present disclosure may have nIT 2 of 60 to 100% based on 12 mN.

When the nIT 2 of the optical film 101 is less than 68%, the restoration force of the optical film 101 when folded and unfolded is insufficient, and fold indentations or pressing indentations may remain. For this reason, the optical film 101 may be inapplicable to foldable or rollable displays.

The optical film 101 according to an embodiment of the present disclosure may have PS2 of 82.00 or more. PS2 is a parameter calculated using the puncture strength and restoration rate (nIT 2) of the optical film 101. PS2 of 82.00 or more means that the optical film 101 has excellent surface properties.

Due to the characteristics of the optical film 101 according to an embodiment of the present disclosure, PS2 may be 270.00 or less. For example, PS2 may range from 82.00 to 150.00, specifically, from 83.00 to 116.00, and more specifically, from 84.00 to 100.00.

According to one embodiment of the present disclosure, the pencil hardness of the optical film 101 may be 1H or more based on a thickness of 55 $\mu$m. Pencil hardness may be measured, for example, by placing the optical film 101 on a glass substrate and measuring pencil hardness on the surface of the optical film 101 disposed on the glass substrate. Specifically, the pencil hardness of the optical film 101 may be measured in accordance with ASTM D 3363 using a pencil hardness meter. The pencil hardness tester may be, for example, a pencil hardness tester from ITOMO.

When the pencil hardness of the optical film 101 is 1H or more, the optical film 101 has excellent surface hardness and thus can suppress deformation due to external force. When the pencil hardness of the optical film 101 is less than 1H, there is a risk of deformation due to external force. More specifically, the optical film 101 according to an embodiment of the present disclosure may have a pencil hardness of 3H or more or 4H or more.

The optical film 101 according to an embodiment of the present disclosure may have a yellowness index (Y.I.) of 2.41 or less based on a thickness of 55 $\mu$m.

The yellowness index of the optical film 101 may be measured using a spectrophotometer according to ASTM E313. The spectrophotometer may, for example, be CM-3700D from KONICA MINOLTA.

When the yellowness index (Y.I.) of the optical film 101 is more than 2.41, the optical film 101 may appear yellow and may be inapplicable to display devices due to insufficient visibility.

The optical film 101 according to an embodiment of the present disclosure may have a light transmittance of 90% or more based on a thickness of 55 $\mu$m and 550 nm.

The light transmittance of the optical film 101 may be measured at a wavelength of 550 nm using a spectrophotometer according to ASTM E313. The spectrophotometer may, for example, be CM-3700D from KONICA MINOLTA.

When the light transmittance of the optical film 101 is less than 90%, the optical film 101 may be inapplicable to display devices due to insufficient visibility.

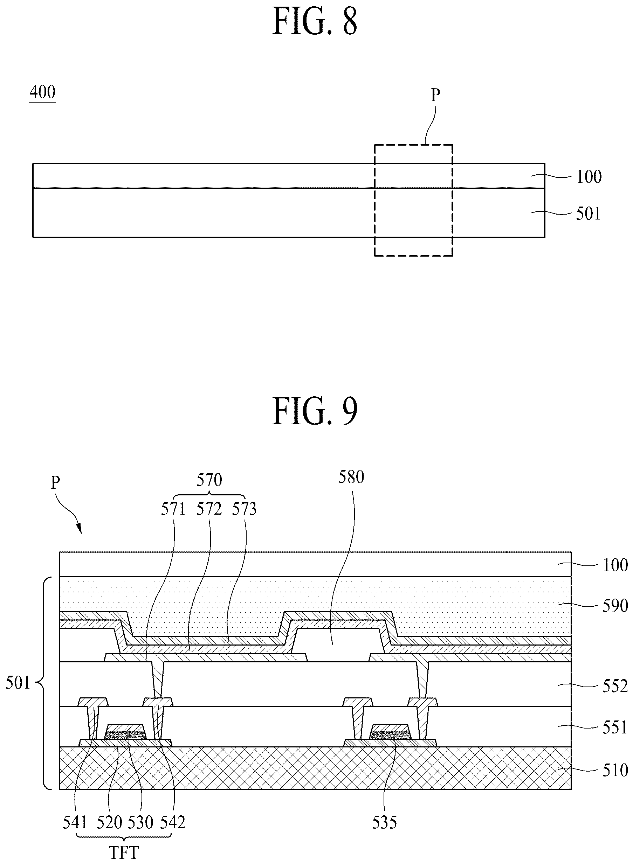

Hereinafter, a display device 400 using the optical film 100 according to an embodiment of the present disclosure will be described with reference to FIGS. 8 and 9. In this case, the used optical film 100 may be the optical film according to FIGS. 2 to 7.

FIG. 8 is a cross-sectional view illustrating a part of a display device 400 according to another embodiment of the present disclosure and FIG. 9 is an enlarged cross-sectional view of "P" in FIG. 8.

Referring to FIG. 6, the display device 400 according to another embodiment of the present disclosure includes a display panel 501 and an optical film 100 on the display panel 501.

Referring to FIGS. 8 and 9, the display panel 501 includes a substrate 510, a thin film transistor TFT on the substrate 510, and an organic light-emitting device 570 connected to the thin film transistor TFT. The organic light-emitting device 570 includes a first electrode 571, an organic light-emitting layer 572 on the first electrode 571, and a second electrode 573 on the organic light-emitting layer 572. The display device 400 shown in FIGS. 8 and 9 is an organic light-emitting display device.

The substrate 510 may be formed of glass or plastic. Specifically, the substrate 510 may be formed of plastic such as a polyimide-based resin or an optical film. Although not shown, a buffer layer may be disposed on the substrate 510.

The thin film transistor TFT is disposed on the substrate 510. The thin film transistor TFT includes a semiconductor layer 520, a gate electrode 530 that is insulated from the semiconductor layer 520 and at least partially overlaps the semiconductor layer 520, a source electrode 541 connected to the semiconductor layer 520, and a drain electrode 542 that is spaced apart from the source electrode 541 and is connected to the semiconductor layer 520.

Referring to FIG. 9, a gate insulating layer 535 is disposed between the gate electrode 530 and the semiconductor layer 520. An interlayer insulating layer 551 may be disposed on the gate electrode 530, and the source electrode 541 and the drain electrode 542 may be disposed on the interlayer insulating layer 551.

A planarization layer 552 is disposed on the thin film transistor TFT to planarize the top of the thin film transistor TFT.

A first electrode 571 is disposed on the planarization layer 552. The first electrode 571 is connected to the thin film transistor TFT through a contact hole provided in the planarization layer 552.

A bank layer 580 is disposed on the planarization layer 552 in a part of the first electrode 571 to define pixel areas or light-emitting areas. For example, the bank layer 580 is disposed in the form of a matrix at the boundaries between a plurality of pixels to define the respective pixel regions.

The organic light-emitting layer 572 is disposed on the first electrode 571. The organic light-emitting layer 572 may also be disposed on the bank layer 580. The organic light-emitting layer 572 may include one light-emitting layer, or two or more light-emitting layers stacked in a vertical direction. Light having any one color among red, green, and blue may be emitted from the organic light-emitting layer 572, and white light may be emitted therefrom.

The second electrode 573 is disposed on the organic light-emitting layer 572.

The first electrode 571, the organic light-emitting layer 572, and the second electrode 573 may be stacked to constitute the organic light-emitting device 570.

Although not shown, when the organic light-emitting layer 572 emits white light, each pixel may include a color filter for filtering the white light emitted from the organic light-emitting layer 572 based on a particular wavelength. The color filter is formed on the light path.

A thin-film encapsulation layer 590 may be disposed on the second electrode 573. The thin-film encapsulation layer 590 may include at least one organic layer and at least one inorganic layer, and the at least one organic layer and the at least one inorganic layer may be alternately disposed.

The optical film 100 is disposed on the display panel 501 having the stack structure described above.

The optical film 100 includes a light-transmitting matrix 110 and a filler 120 dispersed in the light-transmitting matrix 110.

Hereinafter, a method of manufacturing an optical film 101 according to an embodiment of the present disclosure will be described.

The optical film 101 according to an embodiment of the present disclosure may be formed by producing the light-transmitting substrate 110 and then forming a hard coating layer 130 on the light-transmitting substrate 110.

The method of manufacturing an optical film 101 according to an embodiment of the present disclosure includes forming a first reaction solution using a diamine monomer and a dianhydride compound, adding a dicarbonyl compound to the first reaction solution and allowing reaction therebetween to form a second reaction solution, adding a dehydrating agent and an imidization catalyst to the second reaction solution and allowing reaction therebetween to form a third reaction solution, treating the third reaction solution to prepare a polymer resin in a solid phase, dissolving the solid-phase polymer resin to prepare a polymer resin solution, adding an organic additive to the polymer resin solution to prepare a polymer resin composition, and casting the polymer resin composition. Hereinafter, each step will be described in detail.

First, a first reaction solution is formed using a diamine monomer and a dianhydride compound.

The solvent for preparing the first reaction solution may be, for example, a polar aprotic solvent such as N,N-dimethylacetamide (DMAc), N,N-dimethylformamide (DMF), 1-methyl-2-pyrrolidinone (NMP), m-cresol, tetrahydrofuran (THF), chloroform, methyl ethyl ketone (MEK), or a mixture thereof. However, the solvent according to an embodiment of the present disclosure is not limited thereto and other solvents may be used.

According to one embodiment of the present disclosure, the diamine monomer may, for example, include at least one of 2,2'-bis(trifluoromethyl)benzidine (TFDB), 4,4'-oxydianiline (ODA), p-phenylene diamine (para-phenylene diamine, pPDA), m-phenylene diamine (meta-phenylene diamine, mPDA), p-methylene diamine (para-methylene diamine, pMDA), m-methylene diamine (meta-methylene diamine, mMDA), 1,3-bis(3-aminophenoxy) benzene (133APB), 1,3-bis(4-aminophenoxy) benzene (134APB), bis (4-aminophenyl) sulfone, (4DDS), bis(3-aminophenyl)sulfone (3DDS), 9,9-bis(3-fluoro-4-aminophenyl)fluorine (F-BAF), N,N'-bis(4-aminophenyl)benzene-1,4-dicarboxamide (BPTPA), N1,N4-bis(4'-amino-2,2'-bis(trifluoromethyl)-[1,1'-bisphenyl]-4-yl)terephthalamide (BTBA), or N,N'-(2,2'-bis(trifluoromethyl)-[1,1'-biphenyl]-4,4'-diyl)bis(4-aminobenzamide) (AB-TFMB).

However, the diamine monomer according to an embodiment of the present disclosure is not limited thereto and other diamine monomers may be used as well.

According to one embodiment of the present disclosure, the dianhydride compound may, for example, include at least one of cyclobutane-1,2,3,4-tetracarboxylic dianhydride (CBDA), 3,3,4,4-biphenyltetracarboxylic dianhydride (BPDA), 2,2-bis(3,4-dicarboxyphenyl)hexafluoropropane dianhydride (6FDA), 4-(2,5-dioxotetrahydrofuran-3-yl)-1,2,3,4-tetrahydronaphthalene-1,2-dicarboxylic anhydride (TDA), pyromellitic dianhydride (1,2,4,5-benzene tetracarboxylic dianhydride, PMDA), 3,3,4,4-benzophenone tetracarboxylic dianhydride (BTDA), bicyclo[2,2,2]oct-7-ene-2,3,5,6-tetracarboxylic anhydride (BCDA), 9,9-bis(trifluoromethyl)-2,3,6,7-xanthene-tetracarboxylic dianhydride (6FCDA), 9,9-bis(3,4-dicarboxyphenyl) fluorine dianhydride (BPAF), 2'-oxospiro[bicyclo[2.2.1]heptane-2,1'-cyclopentane-3',2''-bicyclo[2.2.1]heptane-5,6:5'',6''-tetracarboxylic dianhydride (CpODA), N,N'-(2,2'-bis(trifluoromethyl)-[1,1'-biphenyl]-4,4'-diyl)bis(1,3-dioxo-1,3-dihydroisobenzofuran-5-carboxamide) (TATFMB), or 4,4-oxydiphthalic dianhydride (ODPA).

However, the dianhydride compound according to an embodiment of the present disclosure is not limited thereto and other dianhydride compounds may be used as well.

According to one embodiment of the present disclosure, the first reaction solution may contain polyamic acid and a polyimide repeating unit.

Then, a dicarbonyl-based compound is added to the first reaction solution and allowed to react to form a second reaction solution. For example, 1 to 24 hours after forming the first reaction solution, a dicarbonyl compound may be added to the first reaction solution. More specifically, a dicarbonyl compound may be added to the first reaction solution 1 to 20 hours after formation of the first reaction solution.

According to one embodiment of the present disclosure, when a dicarbonyl-based compound begins to be added to the first reaction solution, the reaction solution is called "second reaction solution".

According to one embodiment of the present disclosure, the dicarbonyl compound may, for example, include at least one of terephthaloyl chloride (TPC), phthaloyl chloride, isophthaloyl chloride (IPC), 4,4'-biphenyldicarbonyl chloride (DPDOC), or 4,4'-oxybis(benzoyl chloride) (OBBOC).

However, the dicarbonyl compound according to an embodiment of the present disclosure is not limited thereto and other dicarbonyl compounds may be used.

According to one embodiment of the present disclosure, the total equivalent weight of the dianhydride-based compound and the dicarbonyl-based compound may be substantially the same as the equivalent weight of the diamine-based monomer.

According to one embodiment of the present disclosure, the molar ratio of the dianhydride-based compound to the dicarbonyl-based compound may range from 50:50 to 2:98.

More specifically, according to one embodiment of the present disclosure, the molar ratio of the dianhydride-based compound to the dicarbonyl-based compound may range from 10:90 to **2:98.**

Then, a dehydrating agent and an imidization catalyst are added to the second reaction solution and reacted to prepare a third reaction solution.

According to one embodiment of the present disclosure, after the dehydrating agent and imidization catalyst are added to the second reaction solution, stirring is performed under reflux at a temperature of 60°C to 80°C for 30 minutes to 2 hours. As a result, a third reaction solution may be prepared.

As the dehydrating agent, acid anhydride such as acetic anhydride, propionic anhydride, isobutyric anhydride, pivalic anhydride, butyric anhydride, or isovaleric anhydride may be used.

As the imidization catalyst, tertiary amine such as isoquinoline, β-picoline, or pyridine may be used.

Then, the third reaction solution is treated to prepare a solid-phase polymer resin.

To prepare the solid-phase polymer resin, a second solvent may be added to the third reaction solution. The second solvent may, for example, be ethanol, methanol, hexane, distilled water, or the like. The second solvent may be used alone or as a combination of two or more types.

When a solvent that mixes well with the first solvent and has low solubility in the polymer resin is added as the second solvent to the third reaction solution, the solid polymer resin is precipitated as a powder. The precipitate may be filtered and dried to prepare a high-purity solid polymer resin. When liquid components are removed in the process of filtering the precipitate, unreacted monomers, oligomers, additives, and reaction by-products may be removed as well.

The polymer resin thus obtained may be a solid powder and may include an imide repeating unit and an amide repeating unit. The polymer resin may be a polyamide-imide-based resin.

Then, the solid-phase polymer resin is dissolved to prepare a polymer resin solution. The step of preparing the polymer resin solution by dissolving the solid-phase polymer resin in a solvent is called "re-dissolution".

The solvent used to dissolve the solid-phase polymer resin may be the same as any of those used in the polymerization. The solvent that can be used to dissolve the solid-phase polymer resin may, for example, be a polar aprotic organic solvent such as N,N-dimethylacetamide (DMAc), N,N-dimethylformamide (DMF), 1-methyl-2-pyrrolidinone (NMP), m-cresol, tetrahydrofuran (THF), chloroform, methyl ethyl ketone (MEK), or a mixture thereof. However, the solvent according to the present disclosure is not limited thereto and other well-known solvents may also be used.

After the solid-phase polymer resin is dissolved to prepare a polymer resin solution, an organic additive is added to the polymer resin solution to prepare a polymer resin composition. The step of adding the organic additive to the polymer resin solution is also called "posttreatment".

The organic additive according to an embodiment of the present disclosure may include at least one functional group of a hydroxyl group (-OH), a carboxyl group (-COOH), or an aldehyde group (-COH).

For example, the organic additive may include at least one of terephthalic acid, isophthalic acid, 1,3,5-benzenetricarboxylic acid, 1,2,3,4-cyclobutanetetracarboxylic acid, biphenyl-4,4'-dicarboxylic acid, diphenic acid, bisphenol A (diphenylolpropane), hydroquinone, 4,4'-(perfluoropropane-2,2'-diyl)diphthalic acid (6FTA), or pyromellitic acid (PMTA).

However, an embodiment of the present disclosure is not limited thereto and the organic additive may further include carboxylic acid.

According to one embodiment of the present disclosure, the carboxylic acid may be dicarboxylic acid or tricarboxylic acid.

According to one embodiment of the present disclosure, when an unclosed imide ring remains in the polymer, imidization may be finished by re-dehydration so that the imide ring can be completely closed, by adding the organic additive to the polymer resin solution.

Alternatively, by linking unclosed repeating units in the polymer through an organic additive, a network in which the polymer chains constituting the light-transmitting substrate 110 are connected in two or three directions may be formed.

More specifically, by adding an organic additive to a polymer resin solution, the hydrogen bond between the polymer and the organic additive can be formed efficiently, and as a result, even if the optical film is left outside for a long time, it is possible to prevent or suppress moisture from permeating the optical film. As a result, it is possible to prevent or suppress changes in the mechanical properties of the optical film.

According to an embodiment of the present disclosure, by preparing a polymer resin composition by adding the organic additive to the polymer resin solution, the mechanical properties of the light-transmitting substrate 110 according to an embodiment of the present disclosure produced from the polymer resin composition can be improved. For example, the modulus, HV, and nIT of the light-transmitting substrate 110 may be improved and the compression resistance may thus be improved. As a result, mechanical properties, such as compression resistance and dent characteristics, of the optical film 100 including the light-transmitting substrate 110 may be improved.

Then, the polymer resin composition is cast.

A casting substrate is used for casting. There is no particular limitation as to the type of the casting substrate. As the casting substrate, a glass substrate, a stainless steel (SUS) substrate, a Teflon substrate, or the like may be used. According to an embodiment of the present disclosure, an organic substrate may be used as the casting substrate.

Specifically, casting is achieved by applying the polymer resin solution to the casting substrate. A coater, a blade, or the like may be used for casting. According to one embodiment of the present disclosure, for example, a Baker film applicator may be used for casting.

After casting, the polymer resin solution is dried at 80 to 120°C to produce a coating film of the polymer resin. The coating film thus produced may be considered as an intermediate of the light-transmitting substrate 110. After the coating film is pulled taut on a pin-type tenter and fixed thereto, additional heat treatment may be performed at a constant temperature of 240°C to 330°C for 10 to 30 minutes. As a result, a light-transmitting substrate 110 may be manufactured.

The light-transmitting substrate 110 according to an embodiment of the present disclosure includes a repeating unit derived from a monomer or compound having a rigid and short structure, thereby improving mechanical properties, such as modulus and Vickers hardness, and compression resistance. In addition, mechanical properties, such as compression resistance and dent properties, of the optical film 101 including the light-transmitting substrate 110 may be improved.

According to one embodiment of the present disclosure, the light-transmitting substrate 110 may have a thickness of 10 to 100 $\mu$m. When the thickness of the light-transmitting substrate 110 is less than 10 $\mu$m, the impact resistance of the optical films 100 and 101 is reduced, and the function of protecting the display device to external force (impact or pressure) is reduced, and thus the optical films 100 and 101 are unsuitable for the cover window of the display device. On the other hand, when the thickness of the light-transmitting substrate 110 exceeds 100 $\mu$m, the optical films 100 and 101 are excessively thick and the minimum radius of curvature increases during folding, thus resulting in deterioration in the bending characteristics of the optical films 100 and reduction in visibility due to the decrease in light transmittance.

According to one embodiment of the present disclosure, after the light-transmitting substrate 110 is manufactured as described above, the hard coating layer 130 may be formed on the light-transmitting substrate 110.

According to one embodiment of the present disclosure, the hard coating layer 130 may be formed using a hard coating composition containing at least one of an epoxy resin, a siloxane resin, or an acrylate resin.

The hard coating composition according to an embodiment of the present disclosure may include a monomer represented by the following Formula 1 and a monomer represented by the following Formula 2:

[Formula 1] $\quad\quad\quad R^1_n Si(OR^2)_{4-n}$

wherein $R^1$ is a C1-C3 linear, branched or alicyclic hydrocarbon group (preferably an alkylene group) containing an alicyclic epoxy group, $R^2$ is a C1-C3 linear, branched or alicyclic alkyl group, and n is an integer of 1 to 3;

[Formula 2]    $Si(OR^3)_4$

wherein $R^3$ is a C1-C8 linear or branched alkyl group.

The monomer represented by Formula 1 may, for example, include at least one of 3-glycidoxypropyl trimethoxysilane, 3-glycidoxypropyl triethoxysilane, 3-glycidoxypropyl tripropoxysilane, 2-(3,4-epoxycyclohexyl)ethyltrimethoxysilane, 2-(3,4-epoxycyclohexyl)ethyltriethoxysilane, or 2-(3,4-epoxycyclohexyl)ethyltripropoxysilane.

The monomer represented by Formula 2 may, for example, include at least one of tetraethyl orthosilicate (TEOS), tetramethyl orthosilicate (TMOS), tetrapropyl orthosilicate (TPOS), or tetrabutyl orthosilicate (TBOS).

According to one embodiment of the present disclosure, the hard coating composition may further contain an initiator. The initiator may include, for example, at least one of a photopolymerization initiator or a radical initiator.

The optical films 100 and 101 according to an embodiment of the present disclosure have light transparency. In addition, the optical films 100 and 101 are flexible. For example, the optical films 100 and 101 are bendable, foldable, and rollable. The optical films 100 and 101 may have excellent mechanical and optical properties.

According to one embodiment of the present disclosure, the hard coating layer 130 may have a thickness of 0.1 to 10 μm.

When the thickness of the hard coating layer 130 is less than 0.1 μm, it may be difficult to obtain the effect of improving surface properties by the hard coating layer 130. On the other hand, when the thickness of the hard coating layer 130 is more than 10 μm, thus making application to a cover window for a flexible display device difficult due to the increased drag of the optical film 101, and making folding and rolling to a radius of 1.5 mm or 2 mm or less difficult. In addition, the hard coating layer may be more readily deformed or damaged when folding or rolling the flexible display device.

As described above, the optical film 101 according to an embodiment of the present disclosure in which the hard coating layer 130 is formed on the light-transmitting substrate 110 may have a thickness sufficient to protect the display device. For example, the optical film 101 may have a thickness of 20 to 300 μm. More specifically, the optical film 101 may have a thickness of 40 to 200 μm. For example, when the thickness of the optical film 101 according to an embodiment of the present disclosure is 200 μm, the optical film 101 may be applicable to foldable or rollable devices.

Hereinafter, the present disclosure will be described in more detail with reference to Preparation Examples, Comparative Preparation Examples, Examples and Comparative Examples. However, the following Preparation Examples, Comparative Preparation Examples, Examples and Comparative Examples should not be construed as limiting the scope of the present disclosure.

**Preparation Example 1: Preparation of polymer solid**

420.284 g of N,N-dimethylacetamide (DMAc) was charged in a 500 mL reactor equipped with a stirrer, a nitrogen injector, a dropping funnel, a temperature controller, and a cooler while the reactor was purged with nitrogen. Then, the temperature of the reactor was adjusted to 25°C, 32.023 g (0.1 mol) of bis(trifluoromethyl)benzidine (TFDB) was dissolved therein and the temperature of the solution was maintained at 25°C. 4.413 g (0.015 mol) of sBPDA was added thereto and then completely dissolved by stirring for 3 hours. Then, 6.664 g (0.015 mol) of 2,2-bis(3,4-dicarboxyphenyl)hexafluoropropane dianhydride (6FDA) was added thereto and completely dissolved therein. After lowering the reactor temperature to 10°C, 14.211 g (0.070 mol) of terephthaloyl chloride (TPC) was added thereto and reacted at 25°C for 12 hours to obtain a polymer solution with a solid concentration of 12% by weight.

5.22 g of pyridine and 6.74 g of acetic anhydride were added to the obtained polymer solution, stirred for 30 minutes, heated at 80°C, stirred at the same temperature for 1 hour to allow a reaction to occur, and allowed to cool to room temperature. 20L of methanol was added to the obtained polymer solution to precipitate a solid. The precipitated solid was filtered, pulverized, washed with 2L of methanol, and dried under vacuum at 100°C for 6 hours or longer to prepare a polyimide-based polymer solid as a powder. The prepared polyimide-based polymer solid is a polyamide-imide polymer solid.

**<Preparation Example 2: Preparation of polymer solid>**

1032.321 g of N,N-dimethylacetamide (DMAc) was charged in a 2L reactor equipped with a stirrer, a nitrogen injector, a dropping funnel, a temperature controller, and a cooler while the reactor was purged with nitrogen. Then, the temperature of the reactor was adjusted to 25°C, 80.058 g (0.25 mol) of bis(trifluoromethyl)benzidine (TFDB) was dissolved therein and the temperature of the solution was maintained at 25°C. 8.335 g (0.043 mol) of CBDA was added thereto and then completely dissolved by stirring for 3 hours. 18.881 g (0.043 mol) of 6FDA was added thereto and then completely dissolved therein. After lowering the reactor temperature to 10°C, 33.498 g (0.165 mol) of terephthaloyl chloride (TPC) was added thereto and reacted at 25°C for 12 hours to obtain a polymer solution with a solid concentration of 12% by weight.

14.79 g of pyridine and 19.10 g of acetic anhydride were added to the obtained polymer solution, stirred for 30 minutes, heated at 80°C, stirred at the same temperature for 1 hour to allow a reaction to occur, and allowed to cool to room temperature. 40L of methanol was added to the obtained polymer solution to precipitate a solid. The precipitated solid was filtered, pulverized, washed with 6L of methanol, and dried under vacuum at 100°C for 6 hours or longer to prepare a polyimide-based polymer solid as a powder. The prepared polyimide-based polymer solid is a polyamide-imide polymer solid.

**<Comparative Preparation Example 1>**

1061.929 g of N,N-dimethylacetamide (DMAc) was charged in a 2L reactor equipped with a stirrer, a nitrogen injector, a dropping funnel, a temperature controller, and a cooler while the reactor was purged with nitrogen. Then, the temperature of the reactor was adjusted to 25°C, 80.058 g (0.25 mol) of bis(trifluoromethyl)benzidine (TFDB) was dissolved therein and the temperature of the solution was maintained at 25°C. 19.860 g (0.068 mol) of sBPDA was added thereto and then completely dissolved by stirring for 3 hours. 14.438 g (0.033 mol) of 6FDA was added thereto and then completely dissolved therein. After lowering the reactor temperature to 10°C, 30.453 g (0.150 mol) of terephthaloyl chloride (TPC) was added thereto and reacted at 25°C for 12 hours to obtain a polymer solution with a solid concentration of 12% by weight.

17.40 g of pyridine and 22.47 g of acetic anhydride were added to the obtained polymer solution, stirred for 30 minutes, heated at 80°C, stirred at the same temperature for 1 hour to allow a reaction to occur, and allowed to cool to room temperature. 40L of methanol was added to the obtained polymer solution to precipitate a solid. The precipitated solid was filtered, pulverized, washed with 6L of methanol, and dried under vacuum at 100°C for 6 hours or longer to prepare a polyimide-based polymer solid as a powder. The prepared polyimide-based polymer solid is a polyamide-imide polymer solid.

**<Comparative Preparation Examples 2 and 3>**

Polymer solids were prepared in the same manner as in Comparative Preparation Example 1 in accordance with the monomer compositions of Comparative Preparation Examples 2 and 3 disclosed in Table 1 below.

**<Preparation of composition for hard coating>**

223 g (0.90 mol) of 3-methacryloxypropyl triethoxysilane (Shinetsu, KBM-503), 21 g (0.10 mol) of tetraethoxysilane (Dynasilane A, EVONIK), 28 g of $H_2O$, and 0.1 g of NaOH were reacted in a 500 mL glass reactor by stirring for 8 hours at 80°C using a mechanical stirrer to obtain a hard coating composition.

The hard coating composition thus prepared contains a siloxane resin. The siloxane resin measured using GPC had a weight average molecular weight of 6,736 and a PDI of 2.6.

[Table 1]

| Item | Polymer resin (Molar ratio) | | | | | | |
|---|---|---|---|---|---|---|---|
| | Diamine | | | Dianhydride | | | Dicarbon yl |
| | TFDB | 3DDS | 4DDS | BPDA | 6FDA | CBDA | TPC |
| Prepar ation Exampl e1 | 100 | 0 | 0 | 15 | 15 | 0 | 70 |
| Prepar ation Exampl e2 | 100 | 0 | 0 | 0 | 17 | 17 | 66 |
| Compar ative Prepar ation Exampl e1 | 100 | 0 | 0 | 27 | 13 | 0 | 60 |
| Compar ative Prepar ation Exampl e2 | 100 | 0 | 0 | 8 | 12 | 0 | 80 |
| Compar ative Prepar ation Exampl e3 | 100 | 0 | 0 | 30 | 70 | 0 | 0 |

[Table 2]

| Item | Type of solid | Formation of hard coating layer | Additive | |
|---|---|---|---|---|
| | | | Type | Content (molar ratio) |
| Example 1 | Preparat ion Example 1 | X | Compound 1 | 5 |
| Example 2 | Preparat ion Example 1 | X | Compound 1 | 20 |
| Example 3 | Preparat ion Example 1 | X | Compound 1 | 40 |
| Example 4 | Preparat ion Example 1 | X | Compound 2 | 20 |
| Example 5 | Preparat ion Example 1 | X | Compound 3 | 20 |
| Example 6 | Preparat ion Example 1 | X | Compound 4 | 20 |
| Example 7 | Preparat ion Example 1 | X | Compound 5 | 20 |
| Example 8 | Preparat ion Example 1 | X | Compound 6 | 20 |
| Example 9 | Preparat ion Example 1 | X | Compound 7 | 20 |
| Example 10 | Preparat ion Example 1 | X | Compound 8 | 20 |
| Example 11 | Preparat ion Example 1 | X | Compound 9 | 20 |
| Example 12 | Preparat ion Example 1 | X | Compound 10 | 20 |
| Example 13 | Preparat ion Example 2 | X | Compound 3 | 25 |
| Example 14 | Preparat ion Example 2 | O | Compound 3 | 25 |
| Compara tive Example 1 | Preparat ion Example 1 | X | - | - |
| Compara tive Example 2 | Preparat ion Example 1 | X | Compound 11 | 20 |
| Compara tive Example 3 | Preparat ion Example 1 | X | Compound 12 | 20 |
| Compara tive Example 4 | Preparat ion Example 1 | X | Compound 1 | 20 |
| Compara tive Example 5 | Preparat ion Example 1 | X | Compound 1 | 3 |
| Compara tive Example 6 | Preparat ion Example 1 | X | Compound 1 | 55 |
| Compara tive Example 7 | Comparat ive Preparat ion Example1 | X | - | - |
| Compara tive Example 8 | Comparat ive Preparat ion Example2 | X | - | - |
| Compara tive Example 9 | Comparat ive Preparat ion Example3 | X | - | - |
| Compara tive Example 10 | Comparat ive Preparat ion Example1 | O | - | - |
| Compara tive Example 11 | Comparat ive Preparat ion Example2 | O | - | - |
| Compara tive Example 12 | Comparat ive Preparat ion Example3 | O | - | - |

**Example 1**

374.929 g of DMAc was charged in a 500 ml reactor, the temperature of the reactor was maintained at 25°C, and 0.830 g (0.005 mol) of terephthalic acid, corresponding to 5 mol% of the mol of the polymer prepared in Preparation Example 1, was added thereto. Then, the reaction solution was allowed to stand until it was completely dissolved.

Then, the temperature of the reactor was decreased to 10°C and 51.127 g of polyamide-imide (polyimide-based resin powder) obtained as a solid powder in Preparation Example 1 was added thereto. The reaction solution was stirred for 1 hour, the temperature was elevated to 25°C and the reaction solution was allowed to stand until the powder-type molecules were completely dissolved. The amount (g) of powder was obtained by calculating a chemical imidization rate and a precipitation yield as 100%. As a result of this process, a mixed solution of an organic compound and a polyimide polymer solution may be obtained.

Then, the mixed solution was cast. A casting substrate is used for casting. There is no particular limitation as to the type of the casting substrate. The casting substrate may be a glass substrate, a stainless steel (SUS) substrate, a Teflon substrate, or the like. According to an embodiment of the present disclosure, the casting substrate may be, for example, a glass substrate.

After casting at room temperature, the result was slowly dried in a hot air oven at 80°C up to 120°C at a rate of 1°C/min for about 40 minutes to produce a film, and the film was peeled off of the glass substrate and fixed to a frame with pins.

The frame to which the optical film was fixed was slowly heated in a vacuum oven from 100°C to 250°C for 2 hours, cooled slowly and separated from the frame to obtain an optical film. The optical film was heated again at 200°C for 1 minute.

As a result, an optical film 100 having a thickness of 50 $\mu$m was completed.

## Examples 2 to 12

Optical films 100 were manufactured in the same manner as Example 1 under the conditions in Table 1 and these optical films 100 are referred to as "Examples 2 to 12", respectively.

## Example 13

The polyimide-based polymer solid prepared in Preparation Example 2 was dissolved in dimethylacetamide (DMAc) at a concentration of 12.7 wt%, and stirred for a predetermined period of time while maintaining the temperature of the reactor at 10°C to prepare a polymer resin solution.

Then, benzene-1,3,5-triacetic acid was added to the polymer resin solution in an amount of 13.13 g (25 mol%) corresponding to 10.44% of the solid powder. The resulting mixture was stirred for 1 hour and the temperature was raised to 25°C to prepare a liquid polymer resin composition.

The prepared polymer resin composition was cast on a casting substrate. There is no particular limitation as to the type of the casting substrate. The casting substrate may be a glass substrate, a stainless steel (SUS) substrate, a Teflon substrate, or the like. According to an embodiment of the present disclosure, the casting substrate may be, for example, a glass substrate. Specifically, the prepared polymer resin composition was applied to a glass substrate, cast, dried in hot air at 80°C for 20 minutes and dried at 120°C for 20 minutes to prepare a light-transmitting substrate, and then the prepared light-transmitting substrate was peeled off from the glass substrate and then fixed to a frame with pins.

The frame to which the optical film was fixed was hot-air dried in an oven at a constant temperature of 260°C for 10 minutes. As a result, a 50 $\mu$m thick light-transmitting substrate was completed.

## Example 14

An optical film according to Example 14 was manufactured by applying a hard coating composition to the light-transmitting substrate manufactured in Example 13, followed by drying to form a hard coating layer.

Specifically, the prepared hard coating composition was applied to a light-transmitting substrate using a Mayer Bar to form a hard coating composition layer.

The light-transmitting substrate on which the hard coating composition layer was formed was dried in an oven at 100°C for 10 minutes and then subjected to UV exposure (150 mW/cm$^2$, 2 J/cm$^2$) to prepare an optical film provided with a hard coating layer. The thickness of the hard coating layer is 5 $\mu$m.

## Comparative Examples 1 to 6

Optical films 100 were manufactured in the same manner as Example 1 under the conditions in Table 1 and these optical films 100 were referred to as "Comparative Examples 1 to 6", respectively.

## Comparative Example 7

The solid powder-type polymer solid prepared in Comparative Preparation Example 1 was dissolved in dimethylacetamide (DMAc) at a concentration of 12.7 wt%, and stirred for a predetermined period of time while maintaining the temperature of the reactor at 10°C to prepare a polymer resin solution.

The prepared polymer resin solution was cast on a casting substrate. There is no particular limitation as to the type of the casting substrate. The casting substrate may be a glass substrate, a stainless (SUS) substrate, a Teflon substrate, or the like. According to an embodiment of the present disclosure, the casting substrate may be, for example, a glass substrate. Specifically, the prepared polymer resin composition was applied to a glass substrate, cast, dried in hot air at 80°C for 20 minutes and dried at 120°C for 20 minutes to prepare a light-transmitting substrate, and then the prepared light-transmitting substrate was peeled off from the glass substrate and then fixed to a frame with pins.

The frame to which the optical film was fixed was hot-air dried in an oven at a constant temperature of 260°C for 10 minutes. As a result, a 50 μm thick light-transmitting substrate was completed.

**Comparative Examples 8 and 9**

Light-transmitting substrates were produced in the same manner as in Comparative Example 8 in accordance with the monomer compositions of Comparative Preparation Examples 2 and 3 of Table 1 and these are referred to as "Comparative Examples 8 and 9", respectively.

**Comparative Examples 10 to 12**

Optical films according to Comparative Examples 10 to 12 were manufactured in the same manner as in Example 14 by forming a hard coating layer on the light-transmitting substrates produced in Comparative Examples 7 to 9.
Organic additives of Compounds 1 to 12 set forth in Table 2 are as follows.

Compound 1: Terephthalic acid
Compound 2: Isophthalic acid
Compound 3: 1,3,5-benzenetricarboxylic acid
Compound 4: 1,2,3,4-cyclobutanetetracarboxylic acid
Compound 5: Biphenyl-4,4'-dicarboxylic acid
Compound 6: Diphenic acid
Compound 7: Bisphenol A (Diphenylolpropane)
Compound 8: Hydroquinone
Compound 9: 4,4'-(perfluoropropane-2,2'-diyl)diphthalic acid
Compound 10: Pyromellitic acid
Compound 11: Dimethyl isophthalate
Compound 12: Diethyl phthalate

In Table 1, the molar ratio represents a molar ratio based on a total of 100 moles of diamine.
Specifically, the molar ratio of the organic additive based on 100 moles of diamine may correspond to the number of molecules of the organic additive per 100 repeating units of the polymer because the diamine compound reacts with the dianhydride compound, and the dicarbonyl compound to form repeating units of the polymer compound.

**<Method for measuring physical properties>**

The following measurements were performed on the optical films produced in Examples 1 to 14 and Comparative Examples 1 to 12. Measurements requiring samples were performed by producing samples required for each measurement method.

**<Measurement of physical properties of light-transmitting substrate>**

**1) Measurement of yellowness index (Y.I)**

The yellowness index of the optical films with a thickness of 55 μm was measured. Specifically, the yellowness index was measured at a wavelength of 360 to 740 nm using a spectrophotometer in accordance with the ASTM E313 standard. CM-3700D from KONICA MINOLTA was used as the spectrophotometer.

**2) Modulus measurement for calculation of Equation 1 (first modulus, second modulus, third modulus)**

The modulus of the light-transmitting substrate was measured in accordance with ASTM D882 using a universal tensile tester (MODEL 5967) from Instron Corporation.

- Temperature: 25°C
- Humidity: 50 RH%
- Load Cell: 30 KN, Grip: 250 N
- Specimen size: 10 mm
- the first modulus is a modulus measured after allowing the optical film with a thickness of 50 μm to stand at a temperature of 25°C and a humidity of 50% for 2 weeks.
- the second modulus is a modulus measured after measuring the first modulus and then heat-treating the optical film at a temperature of 150°C for 1 hour.

- the third modulus is a modulus measured within 3 hours after manufacturing an optical film with a thickness of 50 $\mu$m.

### 3) Calculation of Equation 1

The value of Equation 1 is calculated by applying the calculated first and second modulus to Equation 1 below.

$$[\text{Equation 1}]$$

$$\text{First modulus}^3 \ / \ \text{Second modulus}^3$$

### 4) Measurement of elongation at break

Elongation at break was measured based on a 50 $\mu$m thick light-transmitting substrate. Specifically, the elongation at break was measured using 5967 from Instron Corporation in accordance with the standards of ASTM-D882. The size of the specimen was 10 mm $\times$ 100 mm, the load cell was 30 KN, the grip was 250N, and the tension rate was 25 mm/min.

### 5) Measurement of modulus (MS, GPa) of light-transmitting substrate to calculate dent index

The modulus of the light-transmitting substrate with a thickness of 50 $\mu$m manufactured in Example 13 and Comparative Examples 7 to 9 was measured in accordance with ASTM D882 using a universal tensile tester (MODEL 5967) from Instron Corporation.

- The modulus was measured after leaving the light-transmitting substrate at a temperature of 25°C and at humidity of 50% for two weeks.
- Temperature: 25°C
- Humidity: 50 RH%
- Load Cell: 30 KN, Grip: 250 N
- Specimen size: 10 mm

### 6) Measurement of Vickers hardness (HV, HV1) of light-transmitting substrate

The light-transmitting substrate with a thickness of 50 $\mu$m, produced in each of Examples 1 to 13 and Comparative Examples 1 to 9, was pressed with a pyramidal diamond tip with a diagonal of 136 degrees in accordance with ISO 14577-1, and the surface hardness of the indentation created was measured. The Vickers hardness of the light-transmitting substrate was obtained by calculating HV1 = A/B, wherein A is the load (kg) and B is the surface area (mm$^2$). The Vickers hardness was measured using, for example, a Vickers hardness meter, HM-2000 from Fisher.

### 7) Measurement of restoration rate (nIT 1) of light-transmitting substrate

The restoration rate of the light-transmitting substrate with a thickness of 50 $\mu$m manufactured in each of Example 13 and Comparative Examples 7 to 9 was measured under the conditions of load: 12 mN/load time: 12s/Creep holding time: 5s/temperature: 24°C and humidity: 40RH% using an HM2000 nanoindenter from Fischer.

### <Measurement of physical properties of optical film including hard coating layer>

### 8) Measurement of Vickers hardness (HV2) of optical film

The optical film with a thickness of 55 $\mu$m, manufactured in each of Example 14 and Comparative Examples 10 to 12, was pressed with a pyramidal diamond tip with a diagonal of 136 degrees in accordance with ISO 14577-1, and the surface hardness of the indentation created was measured. The Vickers hardness of the optical film was obtained by calculating HV2 = C/D, wherein C is the load (kg) and D is the surface area (mm$^2$). The Vickers hardness was measured using, for example, a Vickers hardness meter, HM-2000 from Fisher.

**9) Measurement of restoration rate (nIT 2) of optical film**

The restoration rate of the optical film with a thickness of 55 μm manufactured in each of Example 14 and Comparative Examples 10 to 12 was measured under the conditions of 12 mN/12s/Creep 5s/24°C and 40RH% using an HM2000 nanoindenter from Fischer.

**10) Measurement of puncture strength (PNS, kgf) of optical film**

The puncture strength of the optical film with a thickness of 55 μm produced in each of Example 14 and Comparative Examples 10 to 12 was measured. The puncture strength of the optical film was obtained by measuring a load to puncture the optical film applied to the center thereof at a speed of 5 mm/min in accordance with the ASTM D4830 standard using a universal testing machine (UTM, Instron), a jig (S1-11855, Instron), and a probe with a size of 3.18 mm.

**11) Measurement of yellowness index of optical film**

The yellowness index of the optical film with a thickness of 55 μm produced in each of Example 14 and Comparative Examples 10 to 12 was measured at a wavelength of 550 nm using a spectrophotometer in accordance with the ASTM E313 standard. CM-3700D from KONICA MINOLTA was used as the spectrophotometer.

**12) Measurement of light transmittance (%) of optical film**

The light transmittance at a wavelength of 550 nm of the optical film with a thickness of 55 μm produced in each of Example 14 and Comparative Examples 10 to 12 was measured using a spectrophotometer (CM-3700D, KONICA MINOLTA) in accordance with ASTM E313.

**13) Measurement of pencil hardness of optical film**

The optical film with a thickness of 55 μm produced in each of Example 14 and Comparative Examples 10 to 12 was placed on a glass substrate, and then the pencil hardness of the optical film was measured at a speed of 180 mm/min and at a load of 750 gf using a pencil hardness meter from IMOTO, Japan, in accordance with the ASTM D3363 standard.
The results of measurement of physical properties are shown in Tables 3 to 6 below.

[Table 3]

| Item | Yellowness index (Y. I) | Modulus (GPa) | | | Value of Equation 1 | Elongation at break (%) | Vickers hardness (HV) |
|---|---|---|---|---|---|---|---|
| | | First modulus | Second modulus | Third modulus | | | |
| Example 1 | 1.72 | 7.0 | 6.3 | 6.0 | 1.37 | 25 | 44 |
| Example 2 | 1. 95 | 7.3 | 6.7 | 6.4 | 1.29 | 22 | 49 |
| Example 3 | 2.36 | 7.4 | 7.0 | 6.6 | 1.18 | 13 | 51 |
| Example 4 | 1.72 | 7.2 | 6.6 | 6.3 | 1.30 | 25 | 48 |
| Example 5 | 1.79 | 7.5 | 6.9 | 6.7 | 1.28 | 18 | 50 |
| Example 6 | 1.74 | 7.1 | 6.6 | 6.3 | 1.24 | 22 | 48 |
| Example 7 | 1. 90 | 7.3 | 6.8 | 6.5 | 1.24 | 20 | 48 |
| Example 8 | 1. 88 | 7.3 | 6.6 | 6.2 | 1.35 | 20 | 47 |
| Example 9 | 1.72 | 7.1 | 6.4 | 6.1 | 1.37 | 21 | 47 |
| Example 10 | 1. 69 | 7.1 | 6.4 | 6.1 | 1.37 | 25 | 46 |
| Example 11 | 1.76 | 7.2 | 6.6 | 6.3 | 1.30 | 19 | 48 |
| Example 12 | 2.02 | 7.2 | 6.6 | 6.3 | 1.30 | 21 | 47 |
| Compara tive Example 1 | 1. 69 | 7.0 | 6.0 | 5.9 | 1.59 | 27 | 41 |
| Compara tive Example 2 | 1.67 | 7.0 | 6.0 | 5.9 | 1.59 | 28 | 41 |

(continued)

| Item | Yellowness index (Y. I) | Modulus (GPa) | | | Value of Equation 1 | Elongation at break (%) | Vickers hardness (HV) |
|---|---|---|---|---|---|---|---|
| | | First modulus | Second modulus | Third modulus | | | |
| Compara tive Example 3 | 1. 69 | 7.0 | 6.0 | 5.9 | 1.59 | 29 | 41 |
| Compara tive Example 4 | 1. 69 | 7.1 | 6.0 | 5.9 | 1.66 | 25 | 41 |
| Compara tive Example 5 | 1. 69 | 7.1 | 6.1 | 5.9 | 1.58 | 26 | 42 |
| Compara tive Example 6 | 2. 94 | 7.4 | 7.0 | 6.6 | 1.18 | 7 | 50 |

[Table 4]

| Item | Restoratio n rate of light-transmitti ng substrate (nIT 1, %) | Vickers hardness of light-transmitti ng substrate (HV1, kg/mm$^2$) | Modulus of light-transmitti ng substrate (MS, GPa) | Compressio n strength of light-transmitti ng substrate (PS1) |
|---|---|---|---|---|
| Example 13 | 69.43 | 49.58 | 7.4 | 57.67 |
| Comparati ve Example 7 | 66.51 | 44.65 | 6.5 | 51.81 |
| Comparati ve Example 8 | 67.79 | 40.00 | 4.8 | 45.48 |
| Comparati ve Example 9 | 57.60 | 36.46 | 3.3 | 40.33 |

[Table 5]

| Item | Puncture strength of optical film (PNS, kgf) | Vickers hardness of optical film (HV2, kg/mm$^2$) | Restoration rate of optical film (nIT 2, %) | Compression strength of optical film (PS2) |
|---|---|---|---|---|
| Example 14 | 4.1 | 81.0 | 93.31 | 86.03 |
| Comparative Example 10 | 3.8 | 75.4 | 94.11 | 80.11 |
| Comparative Example 11 | 3.0 | 71.0 | 95.10 | 74.95 |
| Comparative Example 12 | 2.8 | 43.0 | 76.00 | 46.56 |

[Table 6]

| Item | Pencil hardness (H) of optical film | Dent index of optical film | Yellowness index (Y.I.) of optical film | Light transmittan ce of optical film (%) |
|---|---|---|---|---|
| Example 14 | 3 | 4.31 | 1.61 | 91.40 |
| Comparat ive Example 10 | 2 | 2.64 | 2.30 | 91.20 |
| Comparat ive Example 11 | 2 | 2.41 | 6.35 | 88.69 |
| Comparat ive Example 12 | 1 | 0.87 | 1.70 | 91.20 |

As can be seen from the results of measurement in Tables 3 to 6, the optical films of Examples 1 to 12 of the present disclosure all satisfied the values of Equation 1 within the ranges defined above, and all optical films of Example 14 had a dent index of 3.5 or more and thus exhibited excellent surface properties.

However, the optical films of Comparative Examples 1 to 6 did not satisfy the values of Equation 1 within the ranges defined above and all the optical films of Comparative Examples 10 to 12 had a Dent index of less than 3.5 and thus exhibited insufficient surface characteristics.

[Explanation of reference numerals]

100, 101, 200, 201, 202, 300: Optical films
110: Light-transmitting matrix
120: Filler
130: Hard coating layer
140: Optical compensation layer
150: Buffer layer
200: Display device
501: Display panel

**Claims**

1. An optical film comprising a light-transmitting substrate,
   wherein the light-transmitting substrate comprises:

   a polymer resin including a repeating unit; and
   an organic additive,
   wherein the repeating unit comprises at least one of an imide repeating unit or an amide repeating unit, and
   the organic additive comprises at least one functional group of a hydroxyl group (-OH), a carboxyl group (-COOH),
   or an aldehyde group (-COH).

2. The optical film according to claim 1, wherein the functional group of the organic additive forms a hydrogen bond with
   the polymer.

3. The optical film according to claim 1, wherein the imide repeating unit and the amide repeating unit are prepared from a
   diamine-based compound,
   wherein the organic additive is present in an amount of 5 to 50 mole parts based on 100 mole parts of the diamine-
   based compound.

4. The optical film according to claim 1, wherein the organic additive comprises at least one of a benzene ring or an
   alicyclic ring, and
   a sum of the number of benzene rings and the number of alicyclic rings is 10 or less.

5. The optical film according to claim 1, wherein the organic additive has Td (50%) of 180°C or higher,
   wherein the Td is a temperature at which 50% by weight of a total weight of the organic additive is reduced.

6. The optical film according to claim 5, wherein the organic additive comprises at least one of terephthalic acid,
   isophthalic acid, 1,3,5-benzenetricarboxylic acid, 1,2,3,4-cyclobutanetetracarboxylic acid, biphenyl-4,4'-dicarboxylic
   acid, diphenic acid, bisphenol A (diphenylolpropane), hydroquinone, 4,4'-(perfluoropropane-2,2'-diyl)diphthalic acid
   (6FTA), or pyromellitic acid (PMTA).

7. The optical film according to claim 1, wherein the optical film satisfies the following Equation 1:

   $$[\text{Equation 1}]$$

   $$1.0 < \text{First modulus}^3 \, / \, \text{Second modulus}^3 < 1.5$$

   wherein the first modulus is a modulus measured after allowing the optical film with a thickness of 50 $\mu$m to stand
   at a temperature of 25°C and a humidity of 50% for 2 weeks, and
   the second modulus is a modulus measured after measuring the first modulus and then heat-treating the optical
   film at a temperature of 150°C for 1 hour.

8. The optical film according to claim 7, wherein the first modulus is 7.0 GPa or more, and

   the second modulus is 6.0 GPa or more,
   the optical film has a third modulus of 6.0 GPa or more,
   wherein the third modulus is a modulus of an optical film with a thickness of 50 $\mu$m measured within 3 hours after manufacturing the optical film.

9. The optical film according to claim 1, wherein the optical film comprises a hard coating layer on the light-transmitting substrate and has a dent index of 3.5 or more,

wherein the dent index is calculated in accordance with the following Equation 2:

[Equation 2]

$$\text{Dent index} = (PS1 + PS2) \times \text{pencil hardness} \times 0.01$$

wherein PS1 is a compression strength of the light-transmitting substrate,
PS2 is a compression strength of the optical film,
pencil hardness is a pencil hardness of the optical film, and
PS1 is calculated in accordance with the following Equation 3:

[Equation 3]

$$PS1 = MS + HV1 + (nIT1 \times 0.01)$$

wherein MS is a modulus of the light-transmitting substrate,
HV1 is a Vickers hardness of the light-transmitting substrate, and
nIT1 is a restoration rate of the light-transmitting substrate,
PS2 in Equation 2 is calculated in accordance with the following Equation 4:

[Equation 4]

$$PS2 = PNS + HV2 + (nIT2 \times 0.01)$$

wherein PNS is a puncture strength of the optical film,
HV2 is a Vickers hardness of the optical film,
nIT2 is a restoration rate of the optical film,
nIT1 and nIT2 are each measured using a nanoindenter under the conditions of 12 mN/12s/Creep 5s/24°C, 40 RH%, and
the puncture strength is measured in accordance with ASTM D4830.

10. The optical film according to claim 9, wherein PS1 is 55.00 or more.

11. The optical film according to claim 9, wherein nIT1 is 68 to 100%,

HV1 is 47.00 kg/mm$^2$ or more, and
MS is 7.0 GPa or more.

12. The optical film according to claim 9, wherein the hard coating layer has a thickness of 0.1 to 10 $\mu$m.

13. The optical film according to claim 9, wherein PS2 is 82.00 or more.

14. The optical film according to claim 9, wherein nIT2 is 60 to 100%,

PNS is 4.0 kgf or more, and
HV2 is 77.0 kg/mm$^2$ or more.

15. A display device comprising:

a display panel; and
the optical film according to any one of claims 1 to 14 disposed on the display panel.

# FIG. 1

100

110

# FIG. 2

101

130
110

# FIG. 3

102

130
110
120

# FIG. 4

200

140
130
110

# FIG. 5

201

| | |
|---|---|
| | — 130 |
| | — 110 |
| | — 140 |

# FIG. 6

202

| | |
|---|---|
| | — 130 |
| | — 140 |
| | — 110 |

# FIG. 7

300

| | |
|---|---|
| | — 130 |
| | — 110 |
| | — 150 |

# FIG. 8

400

P

100

501

# FIG. 9

P

570
571  572  573

580

100

590

501

552

551

510

541  520  530  542                    535

TFT

# FIG. 10

## INTERNATIONAL SEARCH REPORT

| International application No. |
| --- |
| **PCT/KR2023/020229** |

| A. | CLASSIFICATION OF SUBJECT MATTER |
| --- | --- |

**G02B 1/14**(2015.01)i; **G02B 1/12**(2006.01)i; **G02B 1/04**(2006.01)i; **C08J 5/18**(2006.01)i; **C08L 79/08**(2006.01)i; **C08L 77/00**(2006.01)i

According to International Patent Classification (IPC) or to both national classification and IPC

| B. | FIELDS SEARCHED |
| --- | --- |

Minimum documentation searched (classification system followed by classification symbols)

G02B 1/14(2015.01); B29D 11/00(2006.01); C08G 18/64(2006.01); C08G 69/32(2006.01); C08G 73/10(2006.01); C08G 73/14(2006.01); C08G 77/455(2006.01); C08J 5/18(2006.01); G02B 5/20(2006.01); G03F 7/004(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 이미드(imide), 아마이드(amide), 수산화기(hydroxyl), 카르복실기(carboxyl), 알데하이드기(aldehyde), 반복(repeating)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | KR 10-1935089 B1 (AKRON POLYMER SYSTEMS, INC.) 03 January 2019 (2019-01-03)<br>See paragraphs [0021]-[0342], claims 14 and 18 and figure 1. | 1-6,15 |
| A | | 7-14 |
| A | KR 10-2014-0100279 A (DONGWOO FINE-CHEM CO., LTD.) 14 August 2014 (2014-08-14)<br>See claims 1-9. | 1-15 |
| A | KR 10-2019-0087397 A (KOLON INDUSTRIES, INC.) 24 July 2019 (2019-07-24)<br>See claims 1-3. | 1-15 |
| A | JP 2007-072196 A (TOPPAN PRINTING CO., LTD. et al.) 22 March 2007 (2007-03-22)<br>See claims 1 and 3. | 1-15 |
| A | KR 10-2018-0029774 A (LG CHEM, LTD.) 21 March 2018 (2018-03-21)<br>See claims 1-10. | 1-15 |

☐ Further documents are listed in the continuation of Box C.    ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **18 March 2024** | **18 March 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

| International application No. |
| --- |
| **PCT/KR2023/020229** |

| Patent document cited in search report | | | Publication date (day/month/year) | Patent family member(s) | | | Publication date (day/month/year) |
| --- | --- | --- | --- | --- | --- | --- | --- |
| KR | 10-1935089 | B1 | 03 January 2019 | CN | 104718239 | A | 17 June 2015 |
| | | | | CN | 104718239 | B | 19 June 2018 |
| | | | | JP | 2016-500128 | A | 07 January 2016 |
| | | | | JP | 2018-024867 | A | 15 February 2018 |
| | | | | JP | 6204478 | B2 | 27 September 2017 |
| | | | | TW | 201431953 | A | 16 August 2014 |
| | | | | TW | I633152 | B | 21 August 2018 |
| | | | | US | 2014-0083624 | A1 | 27 March 2014 |
| | | | | WO | 2014-047642 | A1 | 27 March 2014 |
| KR | 10-2014-0100279 | A | 14 August 2014 | None | | | |
| KR | 10-2019-0087397 | A | 24 July 2019 | CN | 105899581 | A | 24 August 2016 |
| | | | | CN | 105899581 | B | 24 November 2017 |
| | | | | EP | 3088440 | A1 | 02 November 2016 |
| | | | | EP | 3088440 | B1 | 19 September 2018 |
| | | | | JP | 2017-503887 | A | 02 February 2017 |
| | | | | JP | 6244470 | B2 | 06 December 2017 |
| | | | | KR | 10-1870341 | B1 | 22 June 2018 |
| | | | | KR | 10-2015-0076114 | A | 06 July 2015 |
| | | | | KR | 10-2018-0068941 | A | 22 June 2018 |
| | | | | TW | 201527356 | A | 16 July 2015 |
| | | | | TW | 201634534 | A | 01 October 2016 |
| | | | | TW | I606083 | B | 21 November 2017 |
| | | | | TW | I638842 | B | 21 October 2018 |
| | | | | US | 2016-0319076 | A1 | 03 November 2016 |
| | | | | US | 9580555 | B2 | 28 February 2017 |
| | | | | US | RE048141 | E1 | 04 August 2020 |
| | | | | WO | 2015-099478 | A1 | 02 July 2015 |
| JP | 2007-072196 | A | 22 March 2007 | None | | | |
| KR | 10-2018-0029774 | A | 21 March 2018 | CN | 108350171 | A | 31 July 2018 |
| | | | | CN | 108350171 | B | 12 January 2021 |
| | | | | EP | 3348598 | A1 | 18 July 2018 |
| | | | | EP | 3348598 | B1 | 03 July 2019 |
| | | | | JP | 2019-506479 | A | 07 March 2019 |
| | | | | JP | 6641585 | B2 | 05 February 2020 |
| | | | | TW | 201819469 | A | 01 June 2018 |
| | | | | TW | I648314 | B | 21 January 2019 |
| | | | | US | 10800882 | B2 | 13 October 2020 |
| | | | | US | 2018-0355110 | A1 | 13 December 2018 |
| | | | | WO | 2018-052221 | A1 | 22 March 2018 |

Form PCT/ISA/210 (patent family annex) (July 2022)